# EUROPEAN PATENT SPECIFICATION

(11) **EP 1 550 707 B1**
(45) Date of publication and mention of the grant of the patent: **23.03.2016**
(21) Application number: 03791337.3
(22) Date of filing: 27.08.2003
(51) Int. Cl.: C09K 11/06, H05B 33/14

(54) **ORGANOMETALLIC COMPLEXES, ORGANIC EL DEVICES, AND ORGANIC EL DISPLAYS**
METALLORGANISCHE KOMPLEXE, ORGANISCHE ELEKTROLUMINESZENZVORRICHTUNGEN UND ORGANISCHE ELEKTROLUMINESZENZDISPLAYS
COMPLEXES ORGANOMETALLIQUES, DISPOSITIFS ORGANIQUES ELECTROLUMINESCENTS ET ECRANS ORGANIQUES ELECTROLUMINESCENTS

(30) Priority: 27.08.2002 JP 2002247816; 27.08.2002 JP 2002247815; 14.02.2003 JP 2003037329
(43) Date of publication of application: 06.07.2005
(60) Divisional application: 10182429.0
(73) Proprietor: UDC Ireland Limited, Dublin 4 (IE)
(72) Inventor: SATOH, Tasuku, c/o FUJITSU LIMITED, Kawasaki-shi, Kanagawa 211-8588 (JP); SOTOYAMA, Wataru, c/o FUJITSU LIMITED, Kawasaki-shi, Kanagawa 211-8588 (JP); SAWATARI, Norio, c/o FUJITSU LIMITED, Kawasaki-shi, Kanagawa 211-8588 (JP); MIYATAKE, Tetsuya, c/o FUJITSU LIMITED, Kawasaki-shi, Kanagawa 211-8588 (JP)
(74) Representative: Maiwald Patentanwalts GmbH
(86) International application number: PCT/JP2003/010847
(87) International publication number: WO 2004/020549

(56) References cited:
- EP-A2- 1 211 257
- WO-A-89/04302
- WO-A-03/076549
- WO-A1-02/15645
- JP-A- 2002 173 674
- JP-A- 2002 203 678
- JP-A- 2002 231 453
- US-A1- 2001 014 391
- CZERWIENIEC RAFAL ET AL: "Monomeric and dimeric Re(I) (tricabonyl) (8-quinolinato) complexes" JOURNAL OF THE CHEMICAL SOCIETY, DALTON TRANSACTIONS, CHEMICAL SOCIETY. LETCHWORTH, GB, no. 19, November 2001 (2001-11), pages 2756-2761, XP002976354 ISSN: 1472-7773
- PATENT ABSTRACTS OF JAPAN vol. 1997, no. 11, 28 November 1997 (1997-11-28) & JP 09 176629 A (TOYO INK MFG CO LTD), 8 July 1997 (1997-07-08)
- LI Y ET AL: "Carbonyl polypyridyl Re(I) complexes as organic electroluminescent material" SYNTHETIC METALS, ELSEVIER SEQUOIA, LAUSANNE, CH, vol. 99, 1999, pages 257-260, XP002247229 ISSN: 0379-6779
- LI Y: "Photoluminescent and electroluminescent properties of phenol-pyridine beryllium and carbonyl polypyridyl Re(I) complexes codeposited films" SYNTHETIC METALS, ELSEVIER SEQUOIA, LAUSANNE, CH, vol. 118, 2001, pages 175-179, XP002247230 ISSN: 0379-6779
- PATENT ABSTRACTS OF JAPAN vol. 2002, no. 10, 10 October 2002 (2002-10-10) & JP 2002 173674 A (FUJI PHOTO FILM CO LTD), 21 June 2002 (2002-06-21) -& JP 2002 173674 A (FUJI PHOTO FILM CO LTD) 21 June 2002 (2002-06-21)
- PATENT ABSTRACTS OF JAPAN vol. 2000, no. 26, 1 July 2002 (2002-07-01) & JP 2001 247859 A (FUJI PHOTO FILM CO LTD), 14 September 2001 (2001-09-14)
- SPELLANE P; WATTS R J: "Luminescence Characterization of Cyclometalated Rhenium(I) Carbonyl Complexes" INORGANIC CHEMISTRY, vol. 32, 1993, pages 5633-5636, XP002368152
- VOGLER A; KUNKELY H: "Excited state properties of organometallic compounds of rhenium in high and low oxidation states" COORDINATION CHEMISTRY REVIEWS, vol. 200-202, 2000, pages 991-1008, XP002368153
- PATENT ABSTRACTS OF JAPAN vol. 2003, no. 03, 5 May 2003 (2003-05-05) -& JP 2002 334787 A (SONY CORP), 22 November 2002 (2002-11-22)
- PATENT ABSTRACTS OF JAPAN vol. 2003, no. 03, 5 May 2003 (2003-05-05) -& JP 2002 334786 A (SONY CORP), 22 November 2002 (2002-11-22)
- JOHNSON C E ET AL: "LUMINESCENT IRIDIUM(I), RHODIUM(I), AND PLATINUM(II) DITHIOLATE COMPLEXES" JOURNAL OF THE AMERICAN CHEMICAL SOCIETY, AMERICAN CHEMICAL SOCIETY, WASHINGTON, DC, US, vol. 105, no. 7, 6 April 1983 (1983-04-06), pages 1795-1802, XP000577188 ISSN: 0002-7863
- CZERWIENIEC RAFAL ET AL.: 'Monomeric and dimeric Re(I) (tricabonyl) (8-quinolinato) complexes' J. CHEM. SOC., DALTON TRANS. no. 19, November 2001, pages 2756 - 2761, XP002976354

## Description

### Technical Field

The present invention relates to an organometallic complex which exhibits phosphorescent, luminescence and is suitable as a luminescent material and color conversion material, etc., an organic EL element using the organometallic complex, and an organic EL display using the organometallic complex or organic EL element.

### Background Art

An organic electroluminescent (EL) element has a structure in which one or a plurality of thin organic material layers is interposed between a negative electrode and a positive electrode. In the organic EL, a hole and an electron are injected into the organic material layer from the positive electrode and the negative electrode, respectively, the recombination energy, which is generated when the hole and electron is recombined in the organic material layer, causes the emission center of the luminescent material in the organic material layer excited, and when electrons in the luminescent material falls from an excited state to a ground state, light is emitted. The organic EL is a light-emitting element which uses this emitted light. The organic EL element has features such as self-luminousness and rapid response, exhibits satisfactory visual properties, is super-slim and lightweight, and is excellent in rapid response and movie display. Thus, it receives high expectations to be applied to flat panel displays. Particularly, since a two-layer (multi-layer) organic EL element comprising an organic thin film having positive hole transport properties (positive hole transport layer) and an organic thin film having electron transport properties (electron transport layer) has been reported (C. W. Tang and S. A. VanSlyke, Applied Physics Letters vol.51, p. 913 (1987)), organic EL elements have recently been attracting attention as a large area light-emitting element which emits light at a low voltage of 10V or less.

In a full color display, it is necessary to have pixels emitting light of three primary colors, blue (B), green (G) and red (R) arranged on a display panel. As the first method, for example, a method in which three types of organic EL elements, each emitting blue (B) light, green (G) light, and red (R) light are arrayed, is known (Japanese Patent Application Laid-Open (JP-A) No. 03-214593). As the second method, for example, a method in which light from an organic EL element emitting white light (which is a mixture of blue (B), green (G) and red (R)) is separated into three primary colors by color filters, is known (JP-A No. 03-19485). However, in the first method, three types of organic EL elements emitting three types of color light must be formed at predetermined position on the substrate in order, thus much time and cost are required for manufacturing a display and it is difficult to manufacture a display having high definition. Further, since each of the three types of organic EL elements have different lifetime, there are difficult problems to solve, for example, change in color tone of display with time occurs. In the second method, since white light (a mixture of blue (B), green (G) and red (R)) is separated into blue (B), green (G) and red (R), there is a fundamental problem that the method has low light-emitting efficiency in principle. Therefore, until now, a full color display having low light-emitting efficiency and long lifetime has not been obtained.

As the third method, for example, a method in which emission from an organic EL element emitting blue light is converted into green (G) light and red (R) light by a color conversion layer using fluorescence (JP-A No. 03-152897). In this third method, since a blue organic EL element is formed over the entire surface of the substrate, at blue pixels, emission is taken out without any conversion, and, at green pixels and red pixels, emission is taken out by converting the wavelength of light-emitting light from the blue organic EL element, display can be efficiently manufactured and theoretical value of light-emitting efficiency is expected to be high. Moreover, since only luminescent material in the blue organic EL element is used as a luminescent material, there is an advantage in that change in color tone of the display with time dose not occur. However, in the case of third method, since color conversion efficiency of the color conversion layer is low, color balance in the display cannot be controlled. In conventional techniques, color balance have been controlled by controlling the current value applied to an organic EL element, however, in this case, deterioration of pixels having specific color of emission the light emitted in a organic EL element is accelerated and depending on the operating time, overall color tone of the display is changed. There has also been proposed a method in which color balance is controlled by controlling luminescent area of each color pixel (JP-A No. 10-39791), however, in this case, since it is required that the luminescent area of pixels, there are problems, for example, that light-emitting efficiency and luminance are decreased and production cost increases.

Therefore, a full color display which is manufactured by the third method, in which an average driving current is constant regardless of light-emitting pixels and color balance is satisfactory without changing light emitting area, has not yet been provided and provision of such full color display are strongly desired.

In order to obtain such full color display, efficiency of color conversion in the color conversion layer are required to be improve. In the color conversion layer, fluorescent material is generally used, for example, when blue light-emitting light emitted by blue organic EL element are converted into red light by a color conversion layer, it is required that the luminescent material contained in the color conversion layer efficiently absorb blue light-emitting emitted from the blue organic EL element and conversion into red light is carried out at high quantum efficiency. However, red fluorescent material having a luminescence peak in red-light wavelength region (600 to 650nm) has usually absorption peak in green-light wavelength region (500 to 600nm), therefore, the red fluorescent material cannot efficiently absorb the blue light-emitting light emitted by blue organic EL element. Therefore, in general, in a color conversion layer where blue light-emitting light are converted in color to red light, a host material which efficiently absorbs blue light is used in combination with the red fluorescent material. In the color conversion layer where the red fluorescent material is used in combination with the host material, blue light is converted in color to red light as follows. Specifically, the host material becomes an excited state by absorbing the blue light and when the host material returns to ground state from the excited state, energy, is emitted. The energy is absorbed by the red fluorescent material to thereby become an excited state and when the red fluorescent material returns to ground state from the excited state, red light is released.

However, in the color conversion layer where the red fluorescent material is used in combination with the host material, most of the red fluorescent material forms association state called excimer when it is dispersed in the host material at high concentration so that emitted light is remarkably weakened (concentration quenching) and light having a different wavelength from that of the original emitted light. Thus, in order to obtain original emitted light, it is required that the red fluorescent material be dispersed in the host material at low concentration. On the contrary, from the viewpoint of the energy transfer efficiency from the host material, it is required that the red fluorescent material be dispersed in the host material at some level of high concentration. There is a problem in that it is extremely difficult to allow the red fluorescent material to be dispersed in the host material at concentration where the excimer is not formed and to allow the energy to be efficiently transferred from the host material to the red fluorescent material. Such color conversion layer and the material therefor to overcome the problem and have excellent color conversion efficiency has not been provided yet.

Separately, proposals have been made to improve light-emitting efficiency in the organic EL element. For example, from the viewpoint of obtaining an organic EL element having high light-emitting efficiency, it has been proposed to dope a small amount of molecules of pigment with high fluorescence as a guest material in a host material which is a main material so as to form a light-emitting layer having high light-emitting efficiency (C. W. Tang, S. A. VanSlyke, and C. H. Chen, Journal of Applied Physics vol.65, p. 3610 (1989)). Although proposals regarding improvement of light-emitting efficiency has been made, they have not been studied in terms of stability, lifetime or the like which are important properties for the organic EL element. It has gradually become clear that organic EL elements deteriorate according to various factors, for example, thermal factors, electrochemical factors, factors due to interface phenomena, etc. Although various kinds of organic EL element has been proposed in the related art (JP-A No. 2002-334787), an organic EL element which exhibits satisfactory light-emitting efficiency, lifetime and stability, etc. simultaneously has not been provided yet.

Further, as luminescent material in the organic EL element, the use of material exhibiting phosphorescent luminescence (JP-A No. 2002-334787). However, in this material, aromatic dithiol is used as a ligand and when the ligand is used as a luminescent material, there is a problem that not only PL quantum efficiency is reduced but also light-emitting efficiency is reduced and half-brightness lifetime is extremely shortened due to decrease of resistance to light.

Czerwieniec Rafal et al (Journal of the Chemical Society Dalton Transactions vol. 19, pp2756-2761, (2001)) discloses a synthetic procedure (reaction between Re(CO)₅Cl and 8-hydroxyquinoline, HOX, in boiling toluene). The procedure leads to the dimeric complex Re₂(CO)₆(OX)₂. In coordinating solvents Re₂(CO)₆(OX)₂ undergoes dissociative solvolysis (via a second order reaction) to form monomeric species of general formula Re(CO)₃(OX)solv. In non-coordinating media, however, the dimeric complex remains unaffected. Molecular structures of both forms (which are in accord with IR absorption spectra) were confirmed by means of X-ray measurements. LAV-VIS spectroscopic (absorption and emission) properties of both newly synthesized Re(I) complexes were investigated and the differences in their luminescence properties were discussed.
Non-patent Document 1
   C. W. Tang and S. A. VanSlyke, Applied Physics Letters vol.51, 913 (1987)
Non-patent Document 2
   C. W. Tang, S. A. VanSlyke, and C. H. Chen, Journal of Applied Physics vol.65,3610 (1989)
Non-patent Document 3
   Czerwieniec Rafal et al, Journal of the Chemical Society Dalton Transactions vol.19, pp2756-2761, (2001)

Patent Document 1
   Japanese Patent Application Laid-Open No. 03-19485
Patent Document 2
   Japanese Patent Application Laid-Open No. 03-19485
Patent Document 3
   Japanese Patent Application Laid-Open No. 03-152897
Patent Document 4
   Japanese Patent Application Laid-Open No.10-39791
Patent Document 5
   Japanese Patent Application Laid-Open No. 2002-334787

The present invention was carried out in view of the current situation and has an object to solve conventional problems and to provide an organometallic complex exhibiting phosphorescent luminescence suitable for use as a luminescent material, color conversion material, etc. in an organic EL element, an organic EL element which has excellent lifetime, light emission efficiency, thermal and electrical stability, color conversion efficiency, etc. and is suitable for lighting units, display devices, etc., and an organic EL display using the organometallic complex or the organic EL element, which has high performance and long lifetime and is suitable for a color display in which a constant average driving current can be achieved regardless of light-emitting pixels and color balance is satisfactory without changing light-emitting area.

### Disclosure of Invention

Inventors of the present invention have investigated vigorously in order to solve the problems described above, and have found the following experiences or discoveries. Specifically, certain organometallic complex exhibiting phosphorescent luminescence is suitable as a luminescent material and color conversion material in an organic EL element and an organic EL element and an organic EL display using the organometallic complex, for example, as a luminescent material, color conversion material, etc. have excellent lifetime and light-emitting efficiency, thermal and electrical stability, etc. and high performance.

According to a first aspect, the present invention provides an organic EL element comprising: a positive electrode, a negative electrode, and an organic thin film layer disposed between the positive electrode and the negative electrode; wherein the organic thin film layer comprises an organometallic complex, wherein the organometallic complex comprises: a rhenium (Re) atom, one ligand which comprises a coordinated nitrogen atom and a coordinated oxygen atom, each coordinated with the rhenium (Re) atom, and comprises at least one n conjugation part, and the other ligand coordinated with the rhenium (Re) atom in such a way that the ligand saturates the coordination number of the rhenium (Re) atom and the charge of the whole organometallic complex is neutral; and wherein the organometallic complex is represented by a formula which is selected from the following formulas (1), (2) and (3): 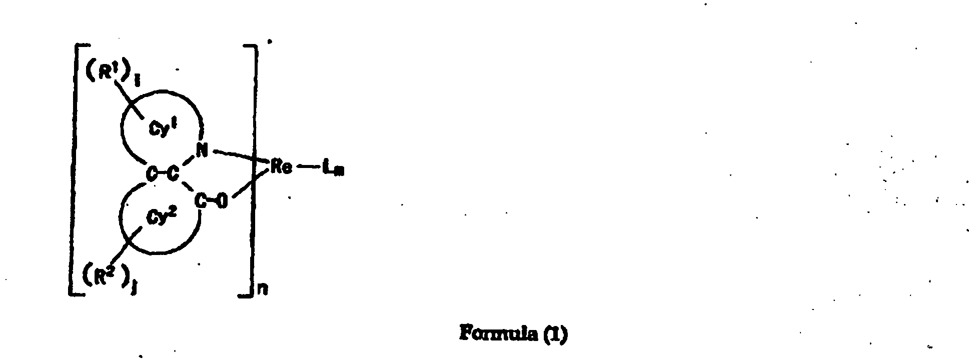 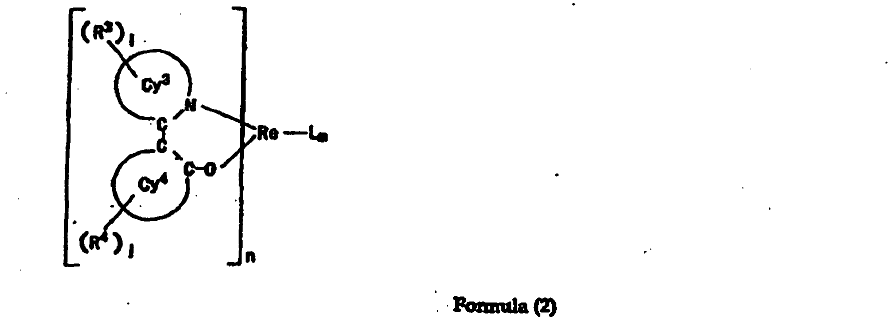 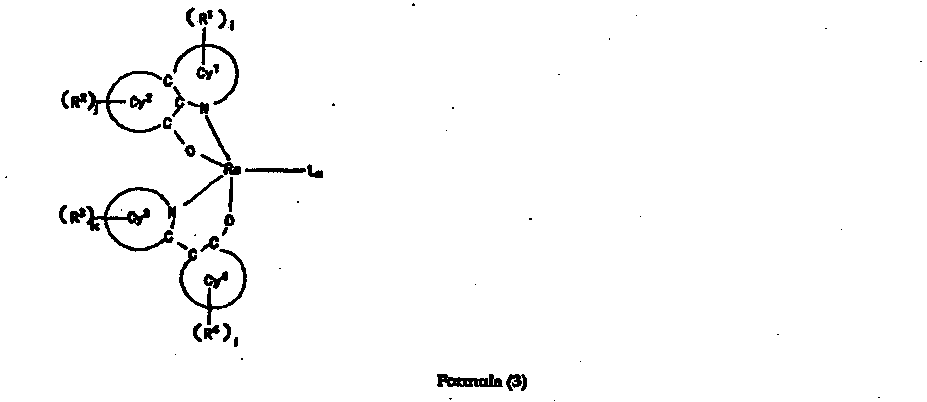 in which, in the formulas (1), (2) and (3), R¹ to R⁴ may be the same or different, and each represent a hydrogen atom or a substituent group; "i", "j", "k" and "1" are integers; Cy¹ represents one ring structure containing a coordinated nitrogen atom which is coordinated with a rhenium (Re) atom, and two carbon atoms which are bonded to the nitrogen atom and are shared with Cy²; Cy² represents the other ring structure which is bonded to the oxygen atom bonded to a rhenium (Re) atom and contains the two carbon atoms shared with Cy¹; Cy³ represents one ring structure containing a coordinated nitrogen atom which is coordinated with a rhenium (Re) atom, and a carbon atom which is bonded to the nitrogen atom and to a carbon atom in Cy⁴; Cy⁴ represents the other ring structure containing a carbon atom which is bonded to the oxygen atom bonded to a rhenium (Re) atom and a carbon atom which is bonded to a carbon atom in Cy³; the letter "L" represents the other ligand which saturates the coordination number of the rhenium (Re) atom, and neutralizes the charge of the whole complex; and "m" represents 1 or 2.

Preferably the organic EL element comprises a color conversion layer, and the color conversion layer is capable of emitting phosphorescence and is capable of converting incident light into light having a wavelength longer than the wavelength thereof by 100 nm or more.

Preferably the color conversion layer is capable of converting incident light into light having a wavelength longer than the wavelength thereof by 150 nm or more.

More preferably, the color conversion layer is capable of converting light in the wavelength range of ultraviolet light to blue light into red light.

Preferably the color conversion layer comprises at least one selected from (1) an organometallic complex which comprises à rhenium (Re) atom; one ligand which comprises a coordinated nitrogen atom and a coordinated oxygen atom, each coordinated with the rhenium (Re) atom, and comprises at least one n conjugation part; and the other ligand coordinated with the rhenium (Re) atom in such a way that the 30 ligand saturates the coordination number of the rhenium (Re) atom and the charge of the whole organometallic complex is neutral, (2) an organometallic complex which comprises an rhenium (Re) atom; one ligand which comprises a coordinated nitrogen atom, a coordinated carbon atom, each coordinated with the rhenium (Re) atom, and 35 comprises at least one n conjugation part; and the other ligand coordinated with the rhenium (Re) atom in such a way that the ligand saturate the coordination number of the rhenium (Re) atom and the charge of the whole organometallic complex is neutral, and (3) an organometallic complex which comprises at least one of Group 8 metal atoms selected from Group 8 metal element; one ligand which comprises at least one n conjugation part and is coordinated with the Group 8 metal atom; and a dithiolate ligand which is selected from an aliphatic dithiolate ligand and a heteroaromatic dithiolate ligand, and is coordinated with the Group 8 metal atom.

Preferably the organic EL element according to the above first aspect is used for lighting units.

According to a second aspect, the present invention provides an organometallic complex which is represented by a formula which is selected from the following formulas (1), (2) and (3): 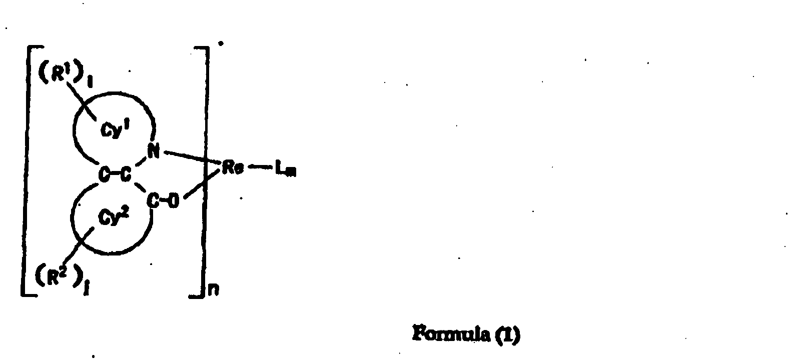 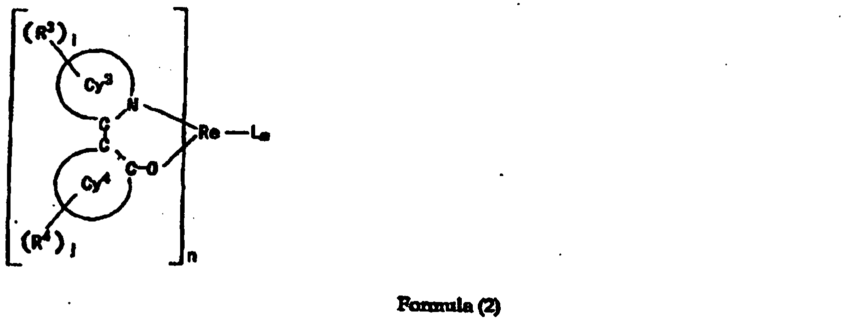 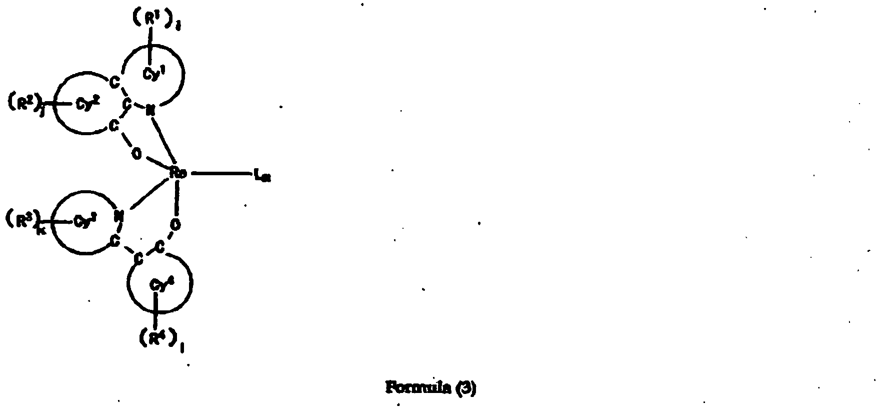 in which, in the formulas (1), (2) and (3), R¹ to R⁴ may be the same or different, and each represent a hydrogen atom or a substituent group; "i", "j", "k" and "l" are integers; Cy¹ represents one ring structure containing a coordinated nitrogen atom which is coordinated with a rhenium (Re) atom, and two carbon atoms which are bonded to the nitrogen atom and are shared with Cy²; Cy² represents the other ring structure which is bonded to the oxygen atom bonded to a rhenium (Re) atom and contains the two carbon atoms shared with Cy¹; Cy³ represents one ring structure containing a coordinated nitrogen atom which is coordinated with a rhenium (Re) atom, and a carbon atom which is bonded to the nitrogen atom and to a carbon atom in Cy⁴; Cy⁴ represents the other ring structure containing a carbon atom which is bonded to the oxygen atom bonded to a rhenium (Re) atom and a carbon atom which is bonded to a carbon atom in Cy³; the letter "L" represents the other ligand which saturates the coordination number of the rhenium (Re) atom, and neutralizes the charge of the whole complex; and "m" represents 1 or 2.

Preferably the organometallic complex is used as at least one of a luminescent material and a color conversion material.

According to a third aspect, the present invention provides an organic EL display which comprises the organic EL element according to the above first aspect.

Preferably the organic EL display further comprises:
a pair of electrodes; an organic thin film layer disposed between the pair of electrodes which is capable of emitting EL light; and a color conversion layer, wherein at least one of the pair of electrodes is transparent and at least one of the pair of electrodes corresponds to pixels, wherein the color conversion layer is arranged on at least a green pixel and a red pixel in the pixels.

Preferably the EL display further comprises:
a color conversion layer arranged on a blue pixel; and a color conversion layer arranged on a red pixel,
wherein light-emitting light due to EL luminescence is white light,
wherein the color conversion layer arranged on a red pixel comprises at least one organometallic complex according to the above second aspect.

Preferably the organic EL display further comprises:
a color conversion layer arranged on a red pixel; and
wherein light-emitting light due to EL luminescence is blue light,
wherein the color conversion layer arranged on a red pixel comprises at least one organometallic complex according to the above second aspect.

By the way, emission from organic substance is classified into fluorescence and phosphorescence by the properties of the excited state, but from the reason that organic substance does not generally generate phosphorescence, fluorescent materials have been conventionally used as a luminescent materials, color conversion material, etc. in an organic EL element. However, from the EL emission mechanism it is anticipated that phosphorescent luminescence state is generated 4 times as much as the luminescence state, therefore, it is effective to apply a heavy metal complex generating phosphorescent luminescence at room temperature to a luminescent material for high efficiency of EL element and such complex has attracted attention in recent years. In the organometallic complexes from the first organometallic complex to the third organometallic complex, since phosphorescent luminescence is generated, high light-emitting efficiency of 100% at maximum can be achieved theoretically compared to the internal quantum efficiency of 25% at maximum of the EL element using fluorescent material. Thus, the organometallic complex is suitable as a luminescent material, color conversion material, etc. in an organic EL element, etc. When the organometallic complexes from the first organometallic complex to the third organometallic complex is used as a color conversion material of color conversion layer in the organic EL element, etc., it is not required to use a host material together in the color conversion layer and, for example, ultraviolet light or blue light can be directly converted into red light using only the organometallic complex.

In each of the organometallic complexes the color of the emitted light can be modified by varying the skeletal structure or substituents of the one ligand, or the other ligand. As the metal center is rhenium (Re), which is a heavy metal with very high melting point and boiling point, the whole organometallic complex has excellent thermal and electrical stability.

Moreover, the one ligand is a bidentate ligand. In the organometallic complex, a nitrogen atom and oxygen atom in the bidentate ligand are directly bonded to the rhenium (Re) atom. In each case, the one ligand (the bidentate ligand) exhibits strong interaction with the rhenium (Re) atom. Thus, in an organic EL element or the like where the organometallic complex is used as luminescent material, color conversion material, etc., when electric field is applied to the organic EL element, strong interaction between the one ligand and the rhenium (Re) atom effectively prevents singlet and triplet excitons that are generated in the organic rhenium complex from deactivating as thermal energy, rotational energy or the like without radiation, and the energy is efficiently changed into light energy as fluorescence and phosphorescence. Hence, if the organometallic complex is, for example, used as a luminescent material, color conversion material, etc. in an organic EL element, emission having excellent lifetime, high light-emitting efficiency, color conversion efficiency, etc. is obtained.

A first organic EL element of the present invention includes an organic thin film layer disposed between a positive electrode and a negative electrode. In the organic EL element, the organic thin film layer includes any one of the organometallic complexes of Formula (1)-(3) as a luminescent material. As the first organic EL element contains the organometallic complex of the present invention, it is excellent in lifetime and light-emitting efficiency, durability, etc.

A second organic EL element of the present invention includes a color conversion layer, wherein, the color conversion layer includes any one of the organometallic complexes of Formula (1)-(3) as a color conversion material. In the second organic EL element, as the color conversion layer includes the organometallic complex of the present invention as a color conversion material, the second organic EL element is excellent in lifetime and color conversion efficiency, and by using only the organometallic complex without using host material together, for example, ultraviolet light or blue light can be directly converted into red light.

Theses organic EL elements of the present invention are, for example, particularly suitable for lighting units, display devices, etc.

The organic EL display of the present invention uses at least one of the organic EL elements from the first organic EL element to the second organic EL of the present invention. As the organic EL display uses the organic EL element of the present invention, it is excellent in lifetime and light-emitting efficiency, color conversion efficiency, etc.

### Brief Description of the Drawings

FIG. 1 is a schematic cross sectional view describing an example of the layer structure in an organic EL element according to the present invention.
FIG. 2 is a schematic view describing an example of the structure of an organic EL display (passive matrix panel) of a passive matrix method.
FIG. 3 is a schematic view describing a circuit of an organic EL display (passive matrix panel) of a passive matrix method shown in FIG. 2.
FIG. 4 is a schematic view describing an example of the structure of an organic EL display (active matrix panel) of an active matrix method.
FIG. 5 is a schematic view describing a circuit of an organic EL display (active matrix panel) of an active matrix method shown in FIG. 4.
FIG. 6 is a schematic view describing an example of the structure of an organic EL display.
FIG. 7 is a schematic view describing an example of the structure of an organic EL display.
FIG. 8 is a schematic view describing an example of the structure of an organic EL display.

### Best Mode for Carrying Out the Invention

### <Organometallic complex>

An organometallic complex of the present invention is an organic rhenium complex and comprises a rhenium (Re) atom; one ligand which has a coordinated nitrogen atom and a coordinated oxygen atom, each coordinated with the rhenium (Re) atom, and has at least one π conjugation part; and the other ligand coordinated with the rhenium (Re) atom in such a way that the ligand saturates the coordination number of the rhenium (Re) atom and the charge of the whole organic rhenium complex is neutral. -First organometallic complex (organic rhenium complex)-

The organic rhenium complex is represented by the following formulae (1) to (3):

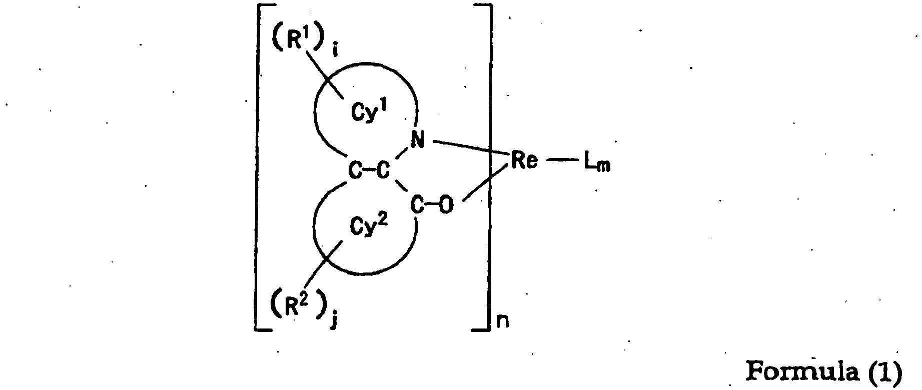

In the formula (1), R¹ and R² may be the same or different, and each represent a hydrogen atom or a substituent group.

There is no particular limitation on the substituent group, and may be selected according to the purpose, for example, a halogen atom, an alkoxy group, an amino group, an alkyl group, a cycloalkyl group, an aryl group which may contain a nitrogen atom or a sulfur atom, or an aryloxy group which may contain a nitrogen atom or a sulfur atom, and these themselves may be substituted.

An adjacent pair of R¹ and R² may be joined together to form an aromatic ring which contains a nitrogen atom, a sulphur atom or an oxygen atom, and the aromatic ring may themselves be substituted by any substituent known in the art.

In the formula (1), "i" and "j" are integers.

In the formula (1), Cy¹ is a ring having a coordinated nitrogen atom which is coordinated with a rhenium (Re) atom, and two carbon atoms which are bonded to this coordinated nitrogen and are shared with Cy².

In the formula (1), Cy² is a ring which is bonded to the oxygen atom bonded to a rhenium (Re) atom and contains the two carbon atoms shared with Cy¹.

There is no particular limitation on the ring represented by the Cy¹ or Cy², and may be selected according to the purpose, suitable examples being 5-membered rings and 6-membered rings, and these rings may contain a carbon atom, a nitrogen atom, an oxygen atom or a sulfur atom.

In the formula (1), "n" is 1, 2, or 3, representing a coordination number of the one ligand coordinated with the rhenium (Re) atom bidentately, the one ligand comprising Cy¹ and Cy².

When n is two or more, each of the one ligands may be the same or different.

In the formula (1), the letter "L" represents the other ligand which saturates the coordination number of the rhenium (Re) atom, and neutralizes the charge of the whole complex. By suitably modifying the "L" ligand, the wavelength of the light emitted by the organic rhenium complex can be varied or adjusted as desired; such that a red light-emitting material, a green light-emitting material or a blue light-emitting material can be obtained.

There is no particular limitation on the other ligand provided that it saturates the coordination number of the rhenium (Re) atom and neutralizes the charge of the whole complex, and it may be selected according to the purpose, but suitable example is a group selected from a halogen atom, a carbonyl group, a cyano group, a hydroxyaryl group, a phenylisocyanide group, a pyridine group, an acetylacetonato group, a 2,2'-bipyridyl group, a 1,10-phenanthroline group, a cyclometalate and ligand group, and a triphenylphosphine group represented as follow. These groups may also be substituted by any substituents known in the art. 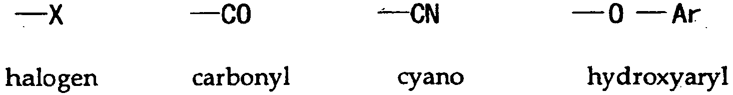 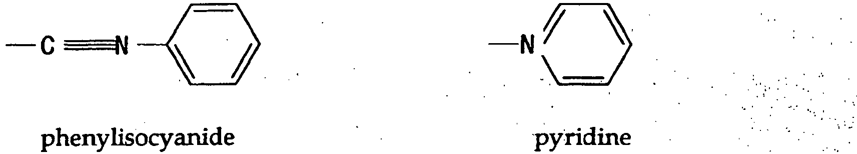 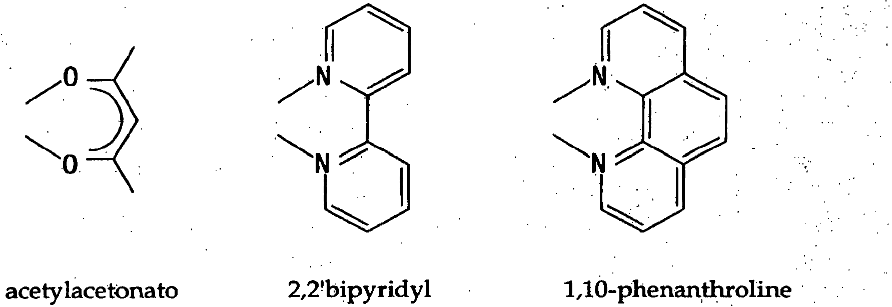 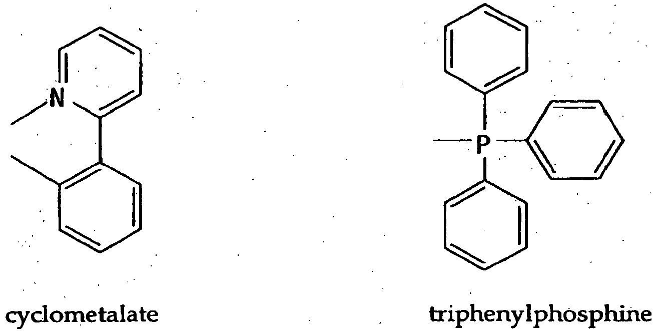 where, in the above formula, Ar represents an aromatic ring or aromatic heterocyclic ring and these may also be substituted by any substituents.

In the formula (1), "m" represents an integer of 0 to 4. It is preferable to select "m" so that the coordination number of the rhenium (Re) atom in the organic rhenium complex is 6, which is a stable coordination number. If n is 1, m is preferably 4, if n is 2, m is preferably 2, and if n is 3, m is preferably 0.

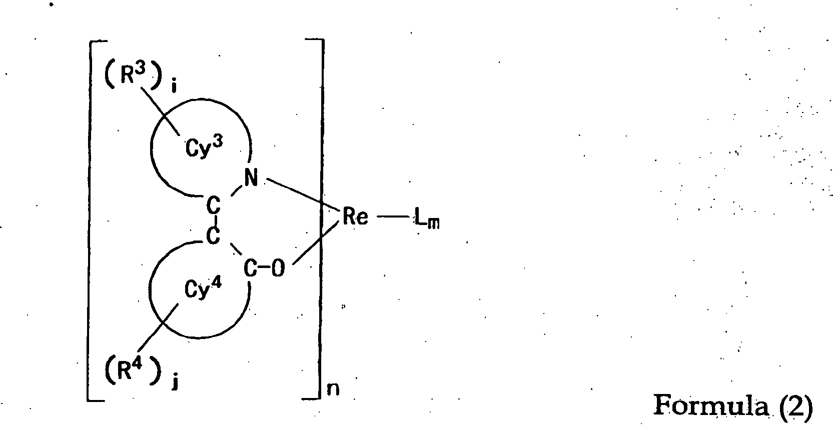

In the formula (2), R³ and R⁴ is the same as R¹ and R² in the formula (1). Moreover, "i" and "j", "n", and, "L" and "m" are the same as those in the formula (1).

The Cy³ is a ring having a coordinated nitrogen atom which is coordinated with a rhenium (Re) atom, and a carbon atom which is bonded to this coordinated nitrogen and a carbon atom in Cy⁴.

The Cy⁴ is a ring having a carbon atom which is bonded to the oxygen atom bonded to a rhenium (Re) atom and a carbon atom which is bonded to carbon atom in Cy³.

There is no particular limitation on the ring represented by the Cy³ and Cy⁴, and may be selected according to the purpose, suitable examples being 5-membered rings and 6-membered rings, and these rings may contain a carbon atom, a nitrogen atom, an oxygen atom or a sulfur atom.

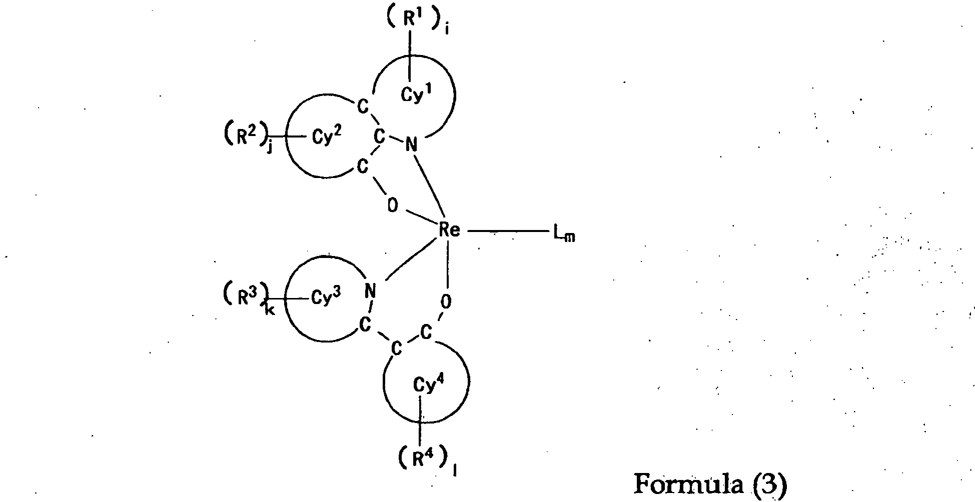

In the formula (3), R¹ to R⁴ may be the same or different, represent a hydrogen atom or substituent group and are the same as R¹ and R² in the formula (1).

"i", "k" and "1" represent an integer and are the same as "i" and "j" in the formula (1).

Cy¹ is a ring having a coordinated nitrogen atom which is coordinated with a rhenium (Re) atom and two carbon atoms which are bonded to this coordinated nitrogen and are shared with Cy², and is the same as the Cy¹ in the formula (1).

Cy² is a ring which is bonded to the oxygen atom bonded to a rhenium (Re) atom and which contains the two carbon atoms shared with Cy¹, and is the same as the Cy² in the formula (1).

Cy³ is a ring having a coordinated nitrogen atom which is coordinated with a rhenium (Re) atom and a carbon atom which is bonded to this coordinated nitrogen and carbon atom in Cy⁴, and is the same as the Cy³ in the formula (2).

Cy⁴ is a ring having carbon atom which is bonded to the oxygen atom bonded to a rhenium (Re) atom and carbon atom which is bounded to carbon atom in Cy³, and is the same as the Cy⁴ in the formula (2).

The letter "L" represents the other ligand which saturates the coordination of the rhenium (Re) atom, and neutralizes the charge of the whole organic rhenium complex, and is the same as the "L" in the formula (1).

Examples of organic rhenium complex are the following formulae (5) to (7):

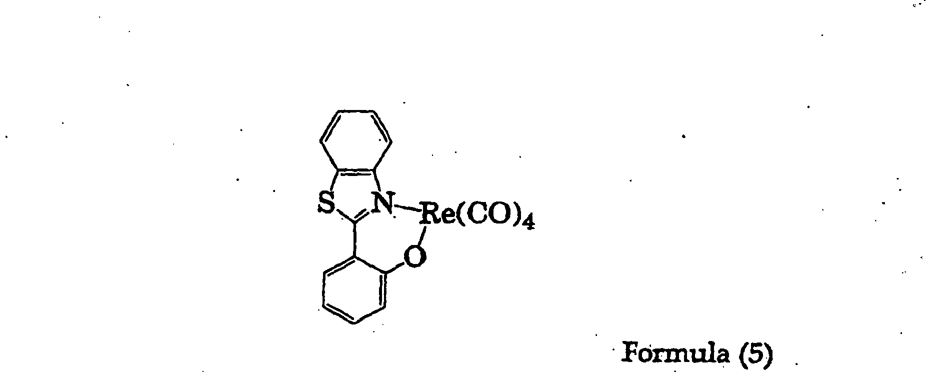

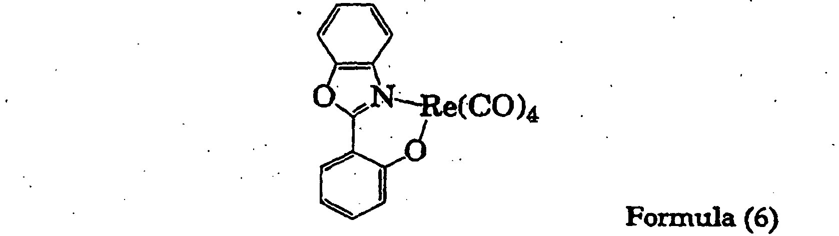

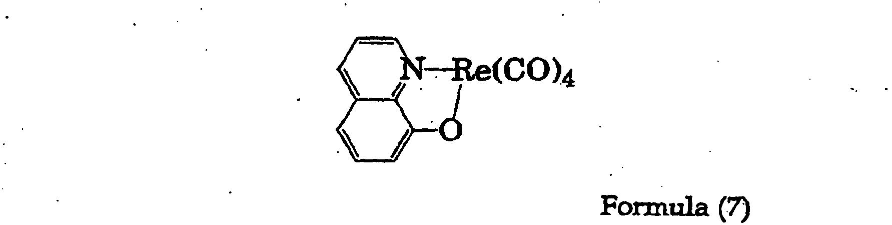

There is no particular limitation on the method of manufacturing the organic rhenium complex which may be suitably selected from the methods known in the art Suitable example includes the method described in Inorg. Chem. 1993, 1, 32, 398-401. For example, in the synthesis of Re(CO)₄(8-quinolinate), Re(CO)₅Cl and 8-quinolinate are reacted in toluene with stirring under reflux until the generation of HCl gas stops. The toluene is evaporated to concentrate the solution and, then add diethyl ether and let the solution cool. A yellow precipitate is filtrated and obtained precipitate is washed with diethyl ether. Then, recrystallization is performed twice using mixed solvent of acetone and diethyl ether, and thus Re(CO)₄(8-quinolinate) as an objective substance can be synthesized.

The number of the one ligand (bidentate ligand) can be set to 2 when Re(CO)₅Cl is used, and can be set to 3 when ReCl₃ is used.

The organometallic complex can be suitably used in a variety of field, but can be particularly suitably used as a luminescent materials, color conversion material, etc. in an organic EL element.

When any one of the organometallic complexes is used as a luminescent material of the light-emitting layer in the organic EL element, red light emission having high luminance and purity can be obtained. Further, when any one of the organometallic complexes is used as a color conversion material of the color conversion layer in the organic EL element, for example, blue light emission of the light-emitting layer can be efficiently converted into green light emission or red light emission, and a full color display having high performance and durability, etc. can be designed.

### <Organic EL element>

The first organic EL element of the present invention comprises an organic thin film layer disposed between a positive electrode and a negative electrode. In the organic EL element, the organic thin film layer contains any one of the organometallic complexes at least as a luminescent material. The organic EL element further comprises other layers such as a color conversion layer.

The second organic EL element of the present invention comprises a color conversion layer. In the organic EL element, the color conversion layer contains any one of the organometallic complexes as a color conversion material. The organic EL element further comprises a positive electrode, an organic thin film layer such as a light-emitting layer, a negative electrode.

In the organic EL element of the present invention, when at least any one of the organometallic complexes of the present invention is used as a luminescent material, the organometallic complex is contained in the organic thin film layer where the organometallic complex may be contained in the light-emitting layer or may be contained in the light-emitting and electron transport layer, light-emitting and positive hole transport layer, etc. Further, when the organometallic complex is used in the light-emitting layer or color conversion layer, the light-emitting layer or color conversion layer may be formed of the organometallic complex alone as a film and may be formed using other materials such as a host material together in addition to the organometallic complex.

In the present invention, when the organometallic complex is used as a luminescent material, the light-emitting layer, light-emitting and electron transport layer, light-emitting and positive hole transport layer, or the like in the organic thin film layer may comprise the organometallic complex of the present invention as a guest material, and in addition to the guest material comprise a host material having an emission wavelength near an absorption wavelength of the guest material. The host material is preferably contained in the light-emitting layer, but may also be contained in a positive hole transport layer or an electron transport layer.

When the guest material and host material are used in conjunction, in a process of organic EL luminescence, the host material is excited first. Since the emission wavelength of the host material and the absorption wavelength of the guest material (the organometallic complex) overlap, excitation energy is efficiently transferred from the host material to the guest material, and since the host material returns to the ground state without emitting light and only the guest material which is in an excited state emits excitation energy as light, the light-emitting efficiency and color purity are excellent. In general, when one kind of luminescent molecule is present or the luminescent molecules are contained at high concentration in a thin film, the luminescent molecules are so close to each other that they interact, and a so-called "concentration quenching" effect occurs wherein the light-emitting efficiency declines. However, when the guest material and host material are used together, the organometallic complex which is the guest compound is dispersed at relatively low concentration in the host compound, so the "concentration quenching" effect is effectively suppressed and an excellent light-emitting efficiency is obtained. The use of the two materials in combination is therefore advantageous. Moreover, by using the guest material together with the host material in the light-emitting layer, as the host material generally has excellent film-forming properties, the combination has excellent film-forming properties while maintaining luminescent properties. There is no particular limitation on the host material, and may be suitably selected according to the purpose, but its emission wavelength is preferably near the optical absorption wavelength of the guest material. Suitable examples are the aromatic amine derivative represented by the following formula (56), the carbazole derivative represented by the following formula (57), the oxine complex represented by the following formula (58), 1,3,6,8-tetraphenylpyrene compound represented by the following formula (59), (4,4'-bis(2,2'-diphenylvinyl)-1,1'-biphenyl (DPVBi)) represented by the following formula (60) (main emission wavelength = 470nm), p-sexiphenyl represented by the following formula (61) (main emission wavelength = 400nm) and 9,9'-bianthryl represented by the following formula (62) (main emission wavelength = 460nm).

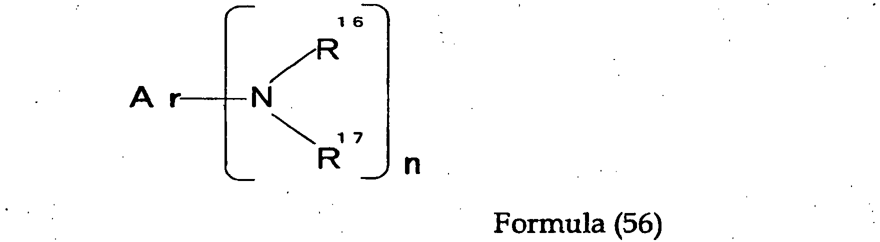

In the formula (56), "n" represents an integer of 2 or 3. Ar represents a divalent or trivalent aromatic group, or heterocyclic aromatic group. R¹⁶ and R¹⁷ may be the same or different, and each represent a monovalent aromatic group or heterocyclic aromatic group. There is no particular limitation on the monovalent aromatic group or heterocyclic aromatic group, and can be selected according to the purpose. Of the aromatic amine derivatives represented by the formula (56), N,N'-dinaphthyl-N,N'-diphenyl-[1,1'-biphenyl]-4,4'-diamine (NPD), which is represented by the following formula (57) (main emission wavelength = 430nm), and its derivatives, are preferred.

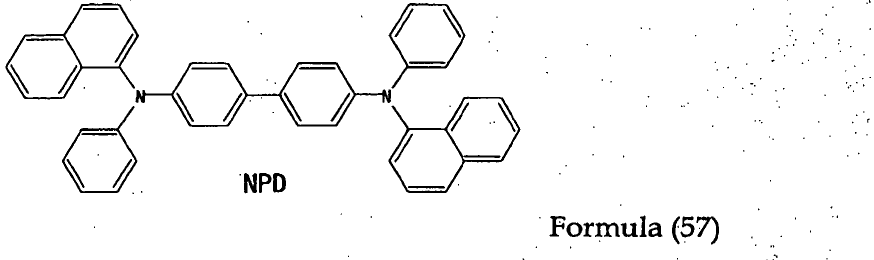

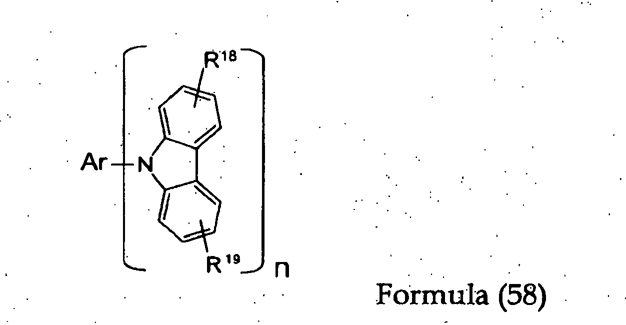

In the formula (58), Ar is a divalent or trivalent group containing an aromatic ring as shown below, or a divalent or trivalent group containing a heterocyclic aromatic ring.

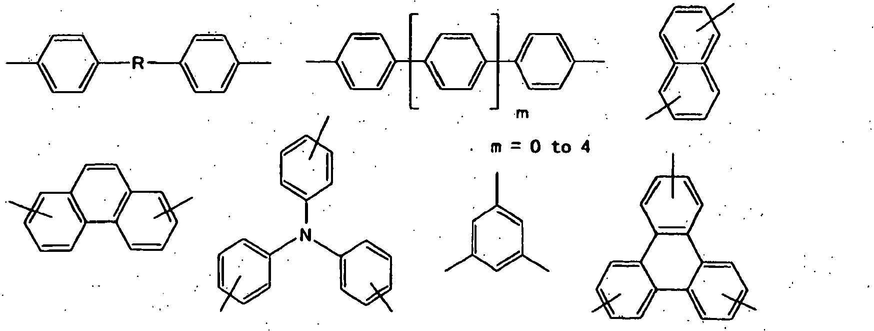

These may be substituted by a non-conjugated group. "R" represents a linking group, the examples of which are shown below.

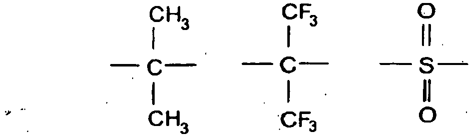

In the formula (58), R¹⁸ and R¹⁹ each independently represent a hydrogen atom, a halogen atom, an alkyl group, an aralkyl group, an alkenyl group, an aryl group, a cyano group, an amino group, an acyl group, an alkoxy carbonyl group, a carboxyl group, an alkoxy group, an alkyl sulfonyl group, a hydroxyl group, an amide group, an aryloxy group, an aromatic hydrocarbon ring or an aromatic heterocyclic group, and these may be further substituted by substituents.

In the formula (58), "n" represents an integer, and 2 and 3 are preferred.

Among the aromatic amine derivatives represented by the formula (58), a compound in which Ar is an aromatic group wherein two benzene rings are connected via a single bond, R¹⁸ and R¹⁹ are hydrogen atoms, and n=2, i.e., 4,4'-bis (9-carbazolyl)-biphenyl (CBP) represented by the following formula (59) (main emission wavelength = 380nm) and its derivatives are preferred in terms of particularly excellent light-emitting efficiency etc.

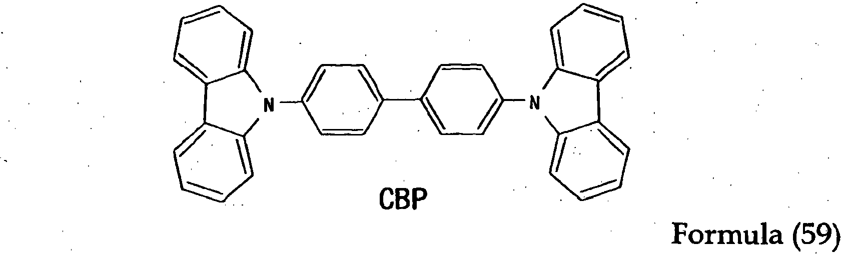

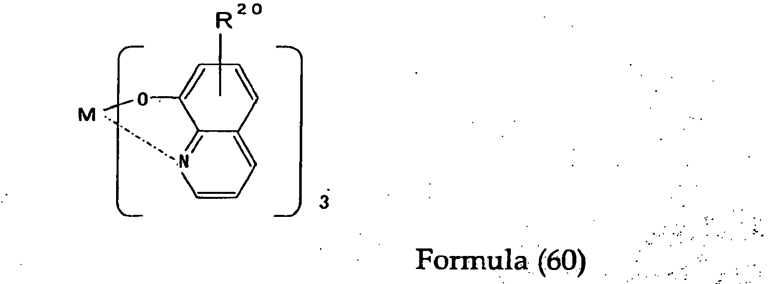

Also, among oxine complexes represented by the formulae (60), the aluminum quinoline complex (Alq) represented by the following formula (61) (main emission wavelength = 530nm) is preferred.

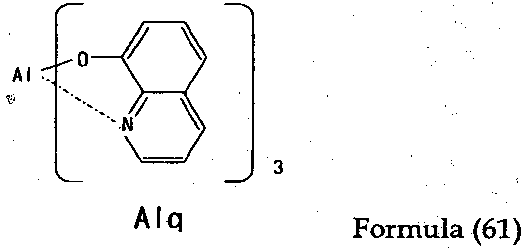

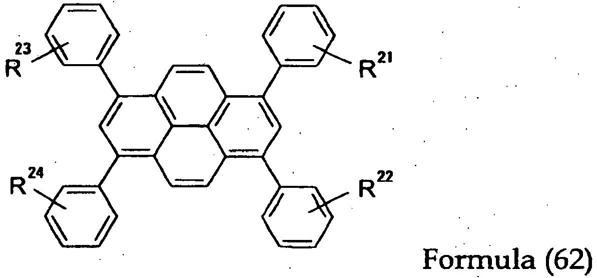

In the formula (62), R²¹ to R²⁴ may be the same or different, and represent a hydrogen atom or substituent group. The substituent may for example be an alkyl group, cycloalkyl group or aryl group, and these may be further substituted by a substituent.

Among the 1,3,6,8-tetraphenylpyrenes represented by the formula (62), the case where R²¹ to R²⁴ are hydrogen atoms, i.e., the 1,3,6,8-tetraphenylpyrene represented by the following formula (63) (main emission wavelength = 440nm) is preferred from the viewpoint of excellent light-emitting efficiency, etc.

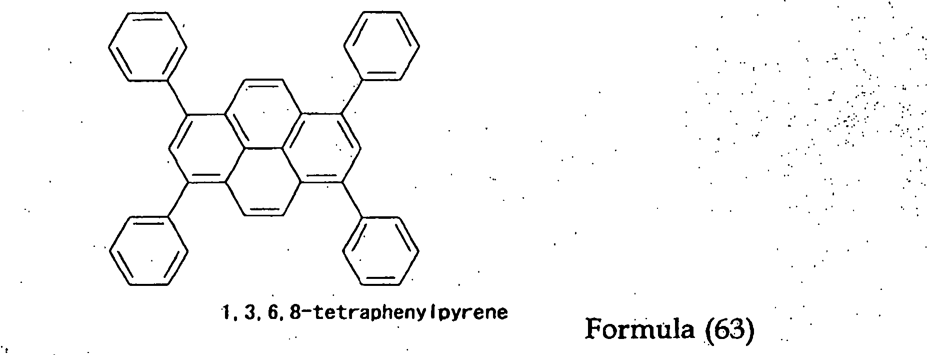

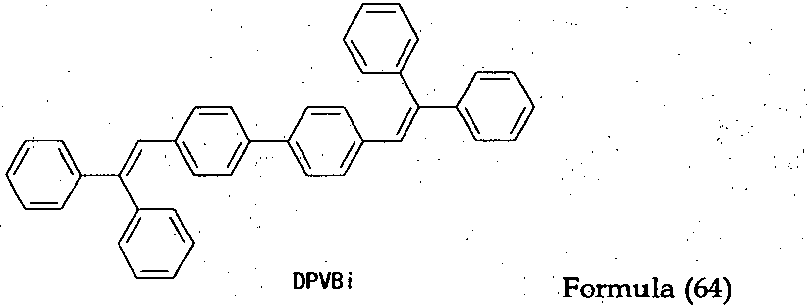

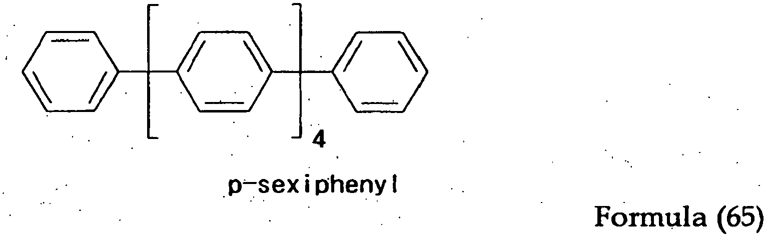

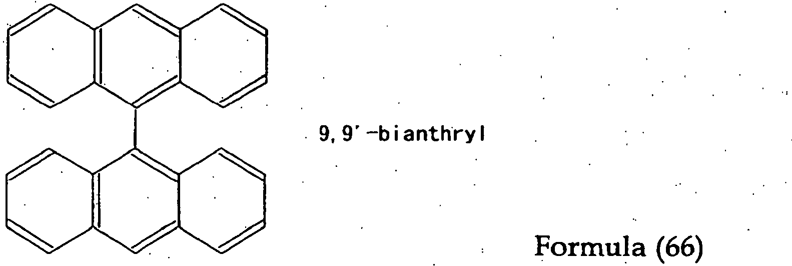

The amount of the organometallic complex in the layer containing the organometallic complex is preferably 0.1 to 50 % by mass, and more preferably 0.5 to 20 % by mass.

When the content is less than 0.1 % by mass, lifetime, light-emitting efficiency, and other properties may not be adequate, and when it exceeds 50 % by mass, color purity may decrease. On' the other hand, when the amount is within the preferred range, lifetime, light-emitting efficiency, etc. are excellent.

Provided that the light-emitting layer in the organic EL element of the present invention may be injected with positive holes from the positive electrode, a positive hole injection layer, the positive hole transport layer or the like and with electrons from the negative electrode, an electron injection layer, the electron transport layer or the like-when an electric field is applied; offers a site for recombination of positive holes and electrons; and has a function to allow the luminescent organometallic complex (luminous material, luminous molecule) to emit light using recombination energy generated by the recombination, the light-emitting layer may contain a luminescent material other than the organometallic complex so long as it does not adversely affect the light emission.

The light-emitting layer can be formed according to known methods, for example, vapor deposition method, wet film forming method, molecular beam epitaxy (MBE) method, cluster ion beam method, molecule laminating method, Langmuir-Brodgett (LB) method, printing method, transfer method, and the like.

Of these, vapor deposition is preferred from the viewpoint that no organic solvent is used so there is no problem of waste fluid treatment, and that manufacture is low cost, simple and efficient. When designing the light-emitting layer as a single layer structure, for example, forming the light-emitting layer as a positive hole transport, light-emitting and electron transport layer, the wet film forming method is also preferred.

There is no particular limitation on the vapor deposition method, which can be conveniently chosen from known methods according to the purpose, for example vacuum vapor deposition, resistance heating vapor deposition, chemical vapor deposition and physical vapor deposition. Examples of chemical vapor deposition are plasma CVD, laser CVD, heat CVD and gas source CVD. Using the vapor deposition method, the light-emitting layer may for example be formed by vacuum vapor deposition of the organometallic complex, or when the light-emitting layer comprises the host material in addition to the organometallic complex, by simultaneous vacuum vapor deposition of the organometallic complex and host material. In the former case, manufacture is easier as co-deposition is not required.

There is no particular limitation on the wet film forming method which can be conveniently chosen from known methods according to the purpose, for example the ink-jet method, spin coating method, kneader coat method, bar coating method, blade coating method, casting method, dip coating method, curtain coating method and the like.

In the wet film forming method, a solution may be used (applied) wherein the material of the light-emitting layer is dissolved or dispersed together with a resin component. Examples of the resin component are polyvinyl carbazole, polycarbonate, polyvinyl chloride, polystyrene, polymethyl methacrylate, polyester, polysulfone, polyphenylene oxide, polybutadiene, a hydrocarbon resin, a ketone resin, a phenoxy resin, polyamide, ethyl cellulose, vinyl acetate, an acrylonitrile butadiene styrene (ABS) resin, polyurethane, a melamine resin, an unsaturated polyester resin, an alkyd resin, an epoxy resin and a silicone resin.

In the wet film forming method, the light-emitting layer may be preferably formed, for example, by using (applying and drying) a solution (coating solution) in which the organometallic complex and, if needed, the resin component are dissolved in a solvent, or when the light-emitting layer comprises the host material in addition to the organometallic complex, by using (applying and drying) a solution (coating solution) in which the organometallic complex, host material and, if needed, the resin component are dissolved in a solvent.

The thickness of the light-emitting layer is preferably 1 to 50nm, more preferably 3 to 20nm.

If the thickness of the light-emitting layer is within the above preferred numerical range, light-emitting efficiency, emission luminance and color purity of the light emitted by the organic EL element are sufficient, and if it is within the more preferred numerical range, these effects are more pronounced.

The organic EL element of the present invention comprises an organic thin film layer containing a light-emitting layer interposed between a positive electrode and a negative electrode, but it may have other layers such as a protective layer, according to the purpose.

The organic thin film layer comprises at least the light-emitting layer, and may also have a positive hole injection layer, positive hole transport layer, positive hole blocking layer, electron transport layer and the like as necessary.

### - Positive electrode -

There is no particular limitation on the positive electrode, which can be conveniently chosen according to the purpose. It is preferred that the positive electrode supplies positive holes (carriers) to the organic thin film layer, specifically, to a light-emitting layer when the organic thin film layer comprises only the light-emitting layer; to a positive hole transport layer when the organic thin film layer further comprises the positive hole transport layer; or to a positive hole injection layer when the organic thin film layer further comprises the positive hole injection layer.

There is no particular limitation on the material of the positive electrode, and can be conveniently chosen according to the purpose, for example, a metal, an alloy, a metal oxide, an electrically conducting compound, mixtures thereof and the like, but among these, materials having a work function of 4eV or more are preferred.

Specific examples of the material of the positive electrode include electrically conducting metal oxides such as tin oxide, zinc oxide, indium oxide, indium tin oxide (ITO), metals such as gold, silver, chromium, and nickel, mixtures or laminates of these metals and electrically conducting metal oxides, inorganic electrically conducting substances such as copper iodide and copper sulfide, organic electrically conducting materials such as polyaniline, polythiophene and polypyrrole, and laminates of these with ITO. These may be used singly, or two or more may be used in combination. Of these, electrically conducting metal oxides are preferred, and ITO is particularly preferred from the viewpoints of productivity, high conductivity and transparency.

There is no particular limitation on the thickness of the positive electrode, and may be determined according to the material, but 1 to 5,000nm is preferred and 20 to 200nm is more preferred.

The positive electrode is typically formed on a substrate such as glass, e.g., soda lime glass or non-alkali glass, or a transparent resin.

When using the glass as the substrate, non-alkali glass or soda lime glass with a barrier layer of silica or the like, are preferred from the viewpoint that they lessen transport of ions from the glass.

There is no particular limitation on the thickness of the substrate provided that it is sufficient to maintain mechanical strength. When using glass as the substrate, it is typically 0.2mm or more, and 0.7mm or more is preferred.

The positive electrode can be conveniently formed by known methods such as vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method, transfer method and the method of applying a dispersion of ITO by a chemical reaction method (sol - gel process etc.).

By washing the positive electrode and performing other treatment, the driving voltage of the organic EL element can be reduced, and the light-emitting efficiency can also be increased. Examples of other treatment include, when the material of the positive electrode is ITO, UV ozonization, plasma processing, and the like.

### - Negative electrode -

There is no particular limitation on the negative electrode, which can be conveniently chosen according to the purpose. It is preferred that the negative electrode supplies electrons to the organic thin film layer, specifically, to a light-emitting layer when the organic thin film layer comprises only the light-emitting layer or to an electron transport layer when the organic thin film layer further comprises the electron transport layer, or to an electron injection layer when the electron injection layer is present between the organic thin film layer and the negative electrode.

There is no particular limitation on the material of the negative electrode, and can be conveniently chosen according to adhesion properties with the layers or molecules adjoining the negative electrode, such as the electron transport layer and light-emitting layer, and according to ionization potential, stability and the like. Examples include a metal, an alloy, a metal oxide, an electrically conducting compound and a mixture thereof.

Examples of the material of the negative electrode include alkali metals (e.g., Li, Na, K, Cs), alkaline earth metals (e.g., Mg, Ca), gold, silver, lead, aluminum, sodium-potassium alloys or mixtures thereof, lithium-aluminum alloys or mixtures thereof, magnesium-silver alloys or mixtures thereof, rare earth metals such as indium and ytterbium, and alloys thereof.

These may be used singly, or two or more may be used in combination. Of these, materials having a work function of 4eV or less are preferred. Aluminum, lithium-aluminum alloys or mixtures thereof, or magnesium-silver alloys or mixtures thereof, are more preferred.

There is no particular limitation on the thickness of the negative electrode, and may be determined according to the material of the negative electrode and the like, but 1 to 10,000nm is preferred and 20 to 200nm is more preferred.

The negative electrode can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

When two or more materials are used together as the material of the negative electrode, the materials may be vapor-deposited simultaneously to form an alloy electrode or the like, or a pre-prepared alloy may be made to vapor-deposit so as to form an alloy electrode or the like.

The resistances of the positive electrode and negative electrode are preferably low, and it is preferred that they are not more than several hundred ohms per square.

### - Positive hole injection layer -

There is no particular restriction on the positive hole injection layer, and can be chosen according to the purpose, but it is preferred that it has the function of, for example, injecting positive holes from the positive electrode when an electric field is applied.

There is no particular limitation on the material of the positive hole injection layer, which can be conveniently chosen according to the purpose. Suitable examples include starburst amine (4,4', 4"-tris[3-methylphenyl(phenyl) amino] triphenylamine: m-MTDATA) represented by the following formula, copper phthalocyanine and polyaniline.

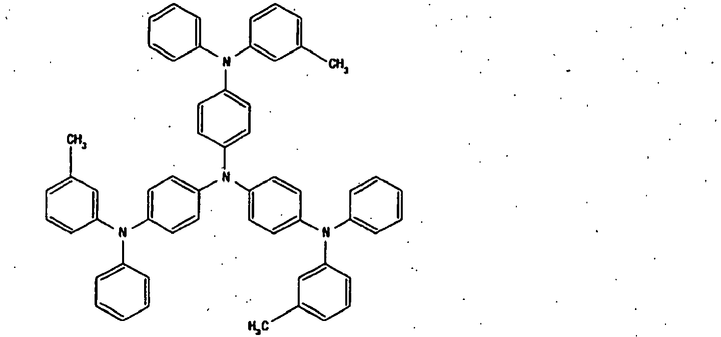

There is no particular limitation on the thickness of the positive hole injection layer, which can be chosen according to the purpose, e.g., about 1 to 100nm is preferred, and 5 to 50nm is more preferred.

The positive hole injection layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

### - Positive hole transport layer -

There is no particular limitation on the positive hole transport layer, and can be chosen according to the purpose, but for example; a layer having the function to convey positive holes from the positive electrode when an electric field is applied, is preferred.

There is no particular limitation on the material of the positive hole transport layer, and can conveniently be chosen according to the purpose. Examples include aromatic amine compounds, carbazole, imidazole, triazole, oxazole, oxadiazole, polyarylalkane, pyrazoline, pyrazolone, phenylene diamine, arylamine, amino-substituted chalcone, styryl anthracene, fluorenone, hydrazone, stilbene, silazane, styryl amine, aromatic dimethylidene compounds, porphyrin compounds, electrically conducting oligomers and polymers such as polysilane compounds, poly(N-vinyl carbazole), aniline copolymers, thiophene oligomers and polymers and polythiophene, and carbon films. If the material of the positive hole transport layer is mixed with the material of the light-emitting layer to form a film, a positive hole transport and light-emitting layer can be formed.

These may be used singly, or two or more may be used in combination. Of these, aromatic amine compounds are preferred. Specifically, TPD (N, N'-diphenyl-N, N'-bis (3-methylphenyl)-[1, 1'-biphenyl]-4,4'-diamine) expressed by the following formula, and NPD (N, N'-dinaphthyl-N, N'-diphenyl-[1,1'-biphenyl]-4,4'-diamine) expressed by the following formula, and the like are more preferred.

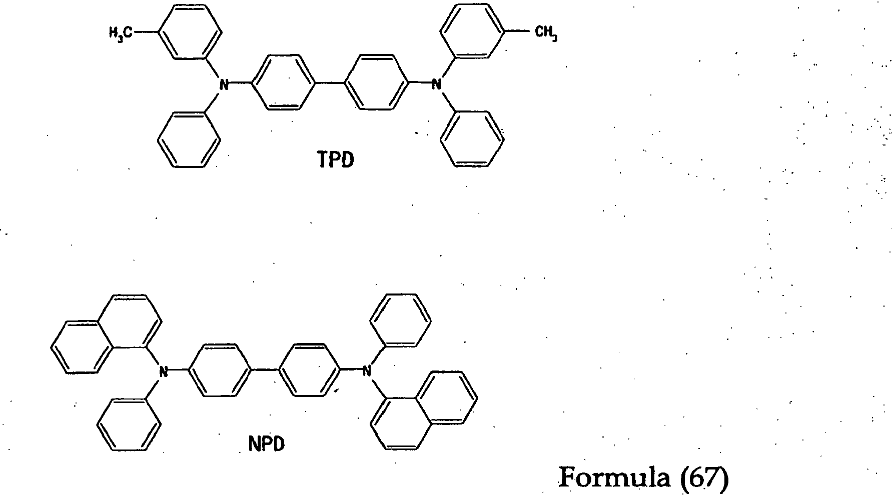

There is no particular limitation on the thickness of the positive hole transport layer, and may be chosen according to the purpose, but is typically in the range of 1 to 500nm, and preferably 10 to 100nm.

The positive hole transport layer can be conveniently formed known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method and transfer method.

### - Positive hole blocking layer-

There is no particular limitation on the positive hole blocking layer, and may be chosen according to the purpose, but a layer having for example the function of a barrier to positive holes injected from the positive electrode, is preferred.

There is no particular limitation on the material of the positive hole blocking layer, and can be conveniently chosen according to the purpose.

If the organic EL element comprises a positive hole blocking layer, positive holes conveyed from the positive electrode side are blocked by the positive hole blocking layer, and electrons conveyed from the negative electrode are transmitted through this positive hole blocking layer to reach the light-emitting layer. Hence, recombination of electrons and positive holes occurs efficiently in the light-emitting layer, and recombination of positive holes and electrons in the organic thin film layer other than the light-emitting layer can be prevented. Thus, the luminescence from the organic rhenium complex, which is the target luminescent material, is obtained efficiently, and this is advantageous in respect of color purity.

The positive hole blocking layer is preferably disposed between the light-emitting layer and the electron transport layer.

There is no particular limitation on the thickness of the positive hole blocking layer which can be conveniently determined according to the purpose, for example it is typically about 1 to 500nm, and preferably 10 to 50nm.

The positive hole blocking layer may be a single layer structure, or may be a laminated structure.

The positive hole blocking layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method or transfer method.

### - Electron transport layer -

There is no particular limitation on the electron transport layer, and may conveniently be chosen according to the purpose, but for example a layer having the function to convey electrons from the negative electrode, or the function to act as a barrier to positive holes injected from the positive electrode, is preferred.

There is no particular limitation on the electron transport layer, and can be selected according to the purpose. Examples include a quinoline derivative such as the aluminum quinoline complex (Alq), an oxadiazole derivative, a triazole derivative, a phenanthroline derivative, a perylene derivative, a pyridine derivative, a pyrimidine derivative, a quinoxaline derivative, a diphenylquinone derivative and a nitro-substituted fluorene derivative. If one of these materials for electron transport layer is mixed with a material for the light-emitting layer to form a film, an electron transport and light-emitting layer can be formed, and if a material for the positive hole transport layer is also mixed to form a film, an electron transport, positive hole transport and light-emitting layer can be formed. In this case, a polymer such as polyvinyl carbazole or polycarbonate can be used.

There is no particular limitation on the thickness of the electron transport layer, and can be conveniently chosen according to the purpose, for example it is typically about 1 to 500nm, and preferably 10 to 50nm.

The electron transport layer may be a single layer structure, or may be a laminated structure.

In this case, it is preferred that an electron transport material used for the electron transport layer adjacent to the light-emitting layer has an optical absorption edge at a shorter wavelength than that of the organic rhenium complex so that it limits the luminescence region in the organic EL element to the light-emitting layer and prevents unwanted luminescence from the electron transport layer. Examples of the electron transport material having an optical absorption edge at a shorter wavelength than the organic rhenium complex include a phenanthroline derivative, an oxadiazole derivative and a triazole derivative. Preferable examples include 2,9-dimethyl-4,7-diphenyl-1,10-phenanthroline (BCP) represented by the following formula (68) and the compounds shown below. 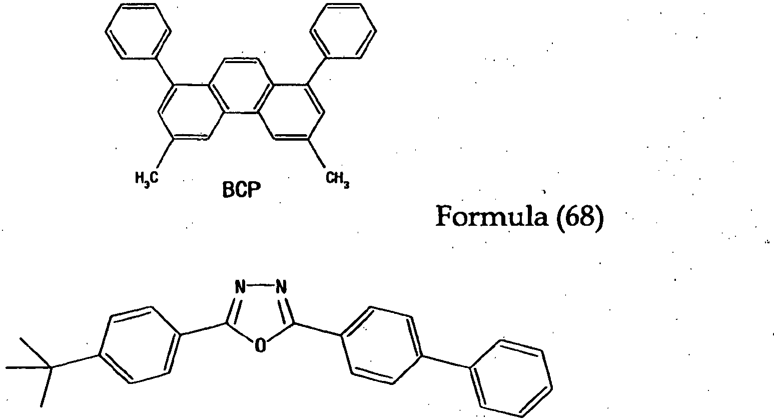 2-(4-tert-butylphenyl)-5-(4-biphenylyl)-1,3,4-oxadiazole 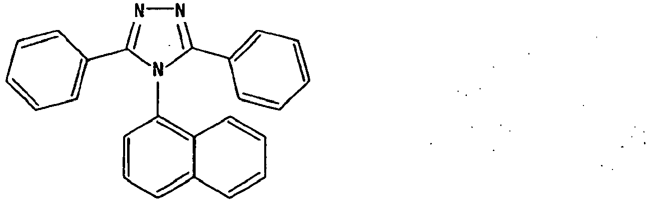 3-phenyl-4-(1-naphthyl)-5-phenyl-1,2,4-triazole 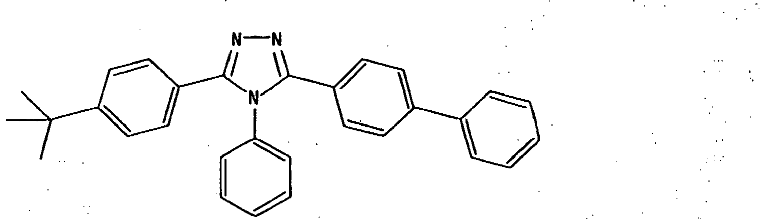 3-(4-tert-butylphenyl)-4-phenyl-5-(4'-biphenylyl)-1,2,4-triazole

The electron transport layer can be conveniently formed by known methods such as the vapor deposition method, wet film forming method, electron beam method, sputtering method, reactive sputtering method, molecular beam epitaxy (MBE) method, cluster ion beam method, ion plating method, plasma polymerization method (high frequency excitation ion plating method), molecule laminating method, Langmuir-Brodgett (LB) method, printing method or transfer method.

### - Other layers -

The organic EL element of the present invention may comprise other layers suitably selected according to the purpose. Suitable examples of such other layers are a color conversion layer, or a protective layer.

In the case of the second organic EL element, the color conversion layer is essential layer and preferably comprises a phosphorescent material, more preferably at least one of the organic rhenium organometallic complexes of the present invention. The color conversion layer may be formed of the organometallic complex alone and may further comprise other materials.

In the color conversion layer, at least any one of the organometallic complexes may be used alone, or two or more may be used in combination.

By the way, it is generally known that the organic molecule excited by light having a certain wavelength loses a part of the excitation energy in the form of thermal energy non-radiatively due to interaction within the molecule or with other molecule before the organic molecule makes transition from excited state to ground state, so the wavelength of the excitation light does not correspond to that of emission light. The energy difference between the excitation light and emission light is called Stokes shift. Until now, as a color conversion material of the color conversion layer, a fluorescent material where only emitting-light from singlet is seen, has been used from the wide range of material selection. Since the fluorescent material has a small stokes shift (<100nm) and emission is seen in the longer wavelength region adjacent to the strongest absorption band, for example, blue-line emission cannot be efficiently absorbed to be converted into red-line color. On the contrary, since at least one of the organometallic complexes is a phosphorescent material, when singlet excitation state is generated due to excitation by certain wavelength light, phosphorescent luminescence can be yielded by transiting to a triplet excitation state which is lower energy state. Thus, the phosphorescent material has larger stokes shift than a fluorescent material (in a case of normal organic material, it is known that a triplet state has lower energy by about 0.1 to 2 eV than singlet excitation state). For example, in the application of converting blue-line emission serving as excitation source into red color, the color conversion layer where a phosphorescent material is used has higher absorption rate of blue light than the layer where a fluorescent material is used, thus led to higher rate of color conversion per molecule. In other words, since the color conversion layer where the fluorescent material is used absorbs less blue light, more blue light transmit the color conversion layer. In order to cover this defect, a color conversion layer may be thickened without changing dispersion concentration, which enables the increase of absorption of blue light and strength of red light. However, in the manufactured organic EL element, exudates from a color conversion layer, such as moisture and residue of organic solvent, causes serious problem that materials constituting the organic EL element deteriorate and non-light-emission region is generated. Therefore, it is desirable that the color conversion layer is as thin as possible. In the color conversion layer where a luminescent material is used, low absorption rate of a guest is covered by using host which absorbs blue light together. However, in case of the color conversion layer where a luminescent material is used, materials serving as a host are not necessarily required to be used together, even in the case where a luminescent material is used alone, high color conversion efficiency, can be achieved. Thus, many problems which are concerned in the color conversion layer manufactured using host together, such as emission from host molecule, deterioration of properties of manufactured color conversion layer and increase of manufacturing cost of the substrate, can be advantageously solved at the same time. In addition, in the case where host is used, as mentioned above, too high concentration of fluorescent material often causes concentration quenching, thus weakening emission remarkably. However, it is known that the phosphorescent material doesn't tend to cause concentration quenching compared with the fluorescent material and the dispersion concentration is not limited. For example, more phosphorescent material emits light even in a powder state compared with a fluorescent material and, on the contrary, too low dispersion concentration weakens emission due to quenching effect by oxygen molecule. When the phosphorescent material is used in a powder state, it is effective from the viewpoint that inhibition of deterioration of the color conversion layer can be achieved. In the color conversion layer, since it is constantly light-exposed in the lithography step at the time of manufacturing a substrate, ITO patterning step and process of color conversion as an element, there is a problem that color conversion efficiency is reduced due to deterioration by light. When luminescent material dispersed in the color conversion layer is used, the material deteriorates extremely rapidly because the luminescent material itself alone is exposed to light and it is extremely difficult to prevent the deterioration. On the contrary, since the color conversion layer in which a phosphorescent material in a power state is used, is exposed to light as a bulk, color conversion layer in which deterioration is reduced, a long lifetime is achieved and conversion efficiency does not change.

There is no particular limitation on the position where the color conversion layer is provided, and can be conveniently chosen according to the purpose, for example, it is preferably provided on the pixels when full color display is conducted.

In the second organic EL element of the present invention, it is required that the color conversion layer is capable of converting incident light into light having a wavelength longer than the wavelength thereof by 100nm or more and is preferably capable of converting incident light into light having a wavelength longer than the wavelength thereof by 150nm or more. In the first organic EL element of the present invention, the color conversion layer is preferably capable of converting incident light into light having a wavelength longer than the wavelength thereof by 100nm or more and is more preferably capable of converting incident light into light having a wavelength longer than the wavelength thereof by 150nm or more.

The color conversion layer is preferably capable of converting light in the wavelength of ultraviolet light to blue light into red light.

There is no particular limitation on the method of forming the color conversion layer, and may be conveniently chosen according to the purpose, but for example, vapor deposition and coating method are preferred.

In the case of the first organic EL element of the present, the color conversion layer is not necessarily essential and may be provided if required. There is no particular limitation on the color conversion layer and may be conveniently chosen according to the purpose. It is preferable that the color conversion layer is formed using at least one of the organometallic complexes of the present invention but color filter, etc. known in the art may be used.

There is no particular limitation on the protective layer, and may be conveniently chosen according to the purpose, but for example a layer which can prevent molecules or substances which promote deterioration of the organic EL element, such as moisture and oxygen, from penetrating the organic EL element, is preferred.

Examples of the material of the protective layer are metals such as In, Sn, Pb, Au, Cu, Ag, Al, Ti and Ni, metal oxides such as MgO, SiO, SiO₂, Al₂O₃, GeO, NiO, CaO, BaO, Fe₂O3, Y₂O₃ and TiO₂, nitrides such as SiN and SiNₓO_{y}, metal fluorides such as MgF₂, LiF, AlF₃, CaF₂, polyethylene, polypropylene, polymethyl methacrylate, polyimide, polyurea, polytetrafluoroethylene, polychlorotrifluoroethylene, polydichlorodifluoroethylene, a copolymer of chlorotrifluoroethylene and dichlorodifluoroethylene, a copolymer obtained by copolymerizing a monomer mixture comprising tetrafluoroethylene and at least one comonomer, a fluorine-containing copolymer having a ring structure in a main chain of the copolymer, a water-absorbing substance having a water absorption rate of 1% or more, and a dampproof substance having a water absorption rate of 0.1% or less.

The protection layer can be conveniently formed by known methods such as the vapor deposition method, wet film forming method, sputtering method, reactive sputtering method, molecular beam epitaxy (MBE) method, cluster ion beam method, ion plating method, plasma polymerization method (high frequency excitation ion plating method), printing method and transfer method.

There is no particular limitation on the structure of the organic EL element of the present invention, and may be chosen according to the purpose. Suitable examples include the following layer compositions (1) to (13):
(1) Positive electrode/positive hole injection layer/positive hole transport layer/light-emitting layer/electron transport layer/electron injection layer/negative electrode,
(2) Positive electrode/positive hole injection layer/positive hole transport layer/light-emitting layer/electron transport layer/negative electrode,
(3) Positive electrode/positive hole transport layer/light-emitting layer/electron transport layer/electron injection layer/negative electrode,
(4) Positive electrode/positive hole transport layer/light-emitting layer/electron transport layer/negative electrode,
(5) Positive electrode/positive hole injection layer/positive hole transport layer/light-emitting and electron transport layer/electron injection layer/negative electrode,
(6) Positive electrode/positive hole injection layer/positive hole transport layer/light-emitting and electron transport layer/negative electrode,
(7) Positive electrode/positive hole transport layer/light-emitting and electron transport layer/electron injection layer/negative electrode,
(8) Positive electrode/positive hole transport layer/light-emitting and electron transport layer/negative electrode,
(9) Positive electrode/positive hole injection layer/positive hole transport and light-emitting layer/electron transport layer/electron injection layer/negative electrode,
(10) Positive electrode/ positive hole injection layer/positive hole transport and light-emitting layer/electron transport layer/negative electrode,
(11) Positive electrode/positive hole transport and light-emitting layer/electron transport layer/electron injection layer/negative electrode,
(12) Positive electrode/positive hole transport and light-emitting layer/electron transport layer/negative electrode,
(13) Positive electrode/positive hole transport, light-emitting and electron transport layer/negative electrode.

When the organic EL element has a positive hole blocking layer, in the (1) to (13), layer compositions wherein the positive hole blocking layer is disposed between the light-emitting layer and electron transport layer are also suitable.

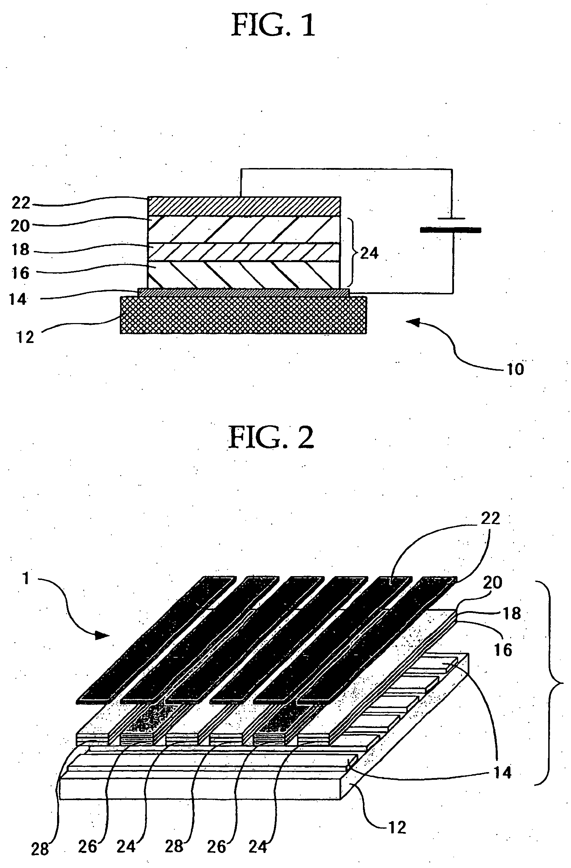

Of these layer compositions, the aspect (4), positive electrode/positive hole transport layer/light-emitting layer/electron transport layer/negative electrode, is shown in FIG.1. An organic EL element 10 has a layer composition comprising an positive electrode 14 (for example, an ITO electrode) formed on a glass substrate 12, a positive hole transport layer 16, a light-emitting layer 18, an electron transport layer 20, and a negative electrode 22 (for example, an Al-Li electrode) laminated in this order. The positive electrode 14 (for example, an ITO electrode) and the negative electrode 22 (for example, an Al-Li electrode) are interconnected through a power supply. An organic thin film layer 24 which emits red light is formed by the positive hole transport layer 16, light-emitting layer 18 and electron transport layer 20.

The luminescence peak wavelength of the organic EL element of the present invention is preferably 600 to 650nm.

From the viewpoint of light-emitting efficiency of the organic EL element of the present invention, it is desired that it emits red light at a voltage of 10V or less, preferably at a voltage of 7V or less, and more preferably at a voltage of 5V or less.

It is preferred that, at an applied voltage of 10V, the emission luminance of the organic EL element of the present invention is 100 cd/m² or more, more preferably 500 cd/m² or more, and particularly preferably 1,000 cd/m² or more.

The organic EL element of the present invention is especially useful in various fields such as lighting units, computers, vehicle-mounted display devices, field-ready display devices, home apparatuses, industrial apparatuses, household electric appliances, traffic display devices, clock display devices, calendar display units, luminescent screens and audio equipment, and is particularly suitable for lighting units and the organic EL display of the present invention, described below.

### <Organic EL display>

There is no particular limitation on the organic EL display of the present invention, and can be chosen from known compositions, except that it uses the organic EL element of the present invention.

The organic EL display may be a monochrome, a multicolor, or a full color type.

The organic EL display may be made a full color type using several methods including those disclosed in "Monthly Display (published by Techno Times Co., Ltd. of Japan)", September 2000, pages 33-37, i.e., (a) the three color light emitting method wherein three types of organic EL elements which, respectively, emit light corresponding to the three primary colors (blue (B), green (G), red (R)) are disposed on a substrate; (b) the white light method wherein white light from an organic EL element for white light emission is divided into the three primary colors via color filters; (c) and the color conversion method wherein blue light emitted by an organic EL element which emits blue light is converted into red (R) and green (G) via a fluorescent pigment layer. In the present invention, as the organic EL element of the invention emits red light, the three color light emitting method and color conversion method can be used, the three color light emitting method being particularly suitable.

When at least any one of the organometallic complexes of the present invention is used as a color conversion material, the color conversion method can particularly preferably be used.

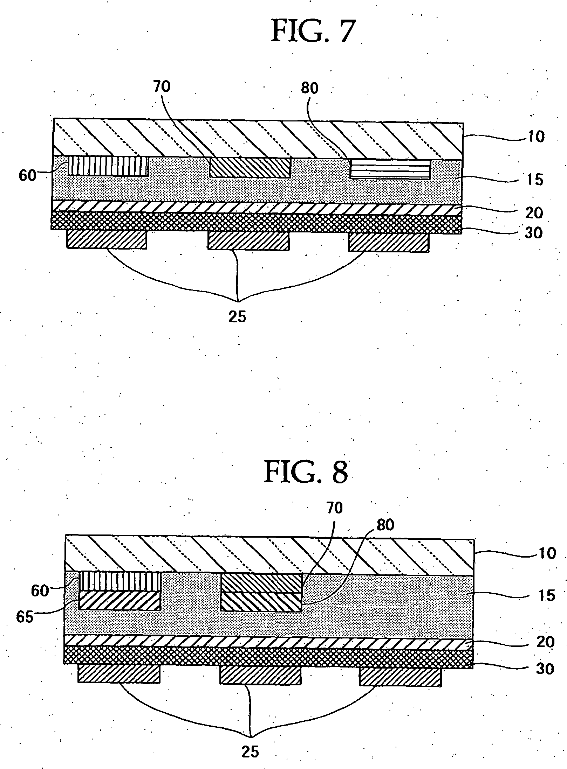

Specific example of the organic EL display of the present invention using the color conversion method includes the organic EL display as shown in FIG. 8. This organic EL display comprises electrodes 25 arranged so as to correspond to pixels and an organic thin film layer 30 for blue light provided over the electrodes, further comprises a transparent electrode 20 thereon. Over the transparent electrode 20, a laminate of color conversion layer for red color 65 and red color filter 60, and a laminate of color conversion layer for green color 80 and green color filter 70 are arranged via a protective layer (planarizing layer) 15, and a glass substrate 10 is provided thereon.

When a voltage is applied between the electrodes 25 and transparent electrode 20 in this organic EL display, the organic thin film layer 30 for blue light emission emits blue light A part of this blue light-emitting light transmits the transparent electrode 20, further transmits the protective layer 15 and glass substrate 10 without conversion, and radiated outside. On the contrary, in the part of the color conversion layer for red color 65 and the part of the color conversion layer for green color 70, the blue light-emitting light is converted into red or green in these color conversion layers and further transmits the red color filter 65 or green color filter 70, thus transmitting the glass substrate 10 as red light-emitting light or green light-emitting light. As a result, a full display can be achieved in the organic EL display.

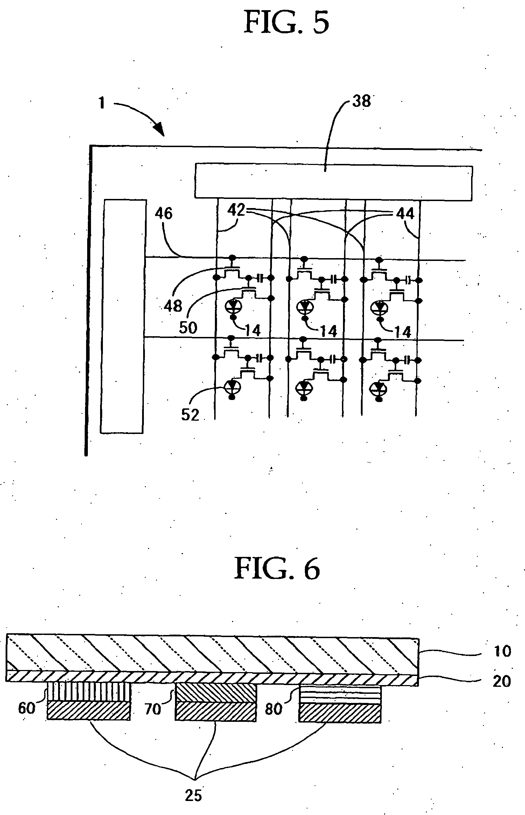

When the color conversion layers 65 and 80 are formed of the organometallic complex (phosphorescent material) of the present invention, a color conversion layer can be formed of a single film composed of the organometallic complex without using host material etc., particularly even in the case of the color conversion layer for red color, and the organic EL display can be easily manufactured and, in addition, and has extraordinary excellent color conversion efficiency. FIG. 6 is a view describing an example of the structure of an organic EL display according to the three color light emitting method. FIG. 7 is a view describing an example of the structure of an organic EL display according to the white light method. The reference character in FIGS. 6 and 7 refers to the same reference number in FIG. 8.

Moreover, in manufacturing a full color organic EL display by the three color light emitting method, the organic EL element of the present invention is used for red light emission, and besides, an organic EL element for green light emission and organic EL element for blue light emission are required.

There is no particular limitation on the organic EL element used for blue light emission which may be selected from among those known in the art, but suitable laminar constructions include ITO (positive electrode)/NPD/Al-Li (negative electrode).

There is no particular limitation on the organic EL element used for green light emission which may selected from among those known in the art, but suitable laminar constructions include ITO (positive electrode)/NPD/Alq/Al-Li (negative electrode).

There is no particular limitation on the aspects of the organic EL display, and may be chosen according to the purpose. Examples include a passive matrix panel and active matrix panel disclosed in Nikkei Electronics (published by Nikkei Business Publications Inc. of Japan), No. 765, March 13, 2000, pages 55-62.

The passive matrix panel for example has belt-like positive electrodes 14 (for example, ITO electrodes) arranged parallel to each other on a glass substrate 12 as shown in FIG. 2. On the positive electrodes 14, belt-like organic thin film layers 24 for red light emission, organic thin film layers 26 for blue light emission and organic thin film layers 28 for green light emission are arranged sequentially in parallel and substantially perpendicular to the positive electrodes 14. Each of the organic thin film layers has negative electrodes 22 of identical shape thereon.

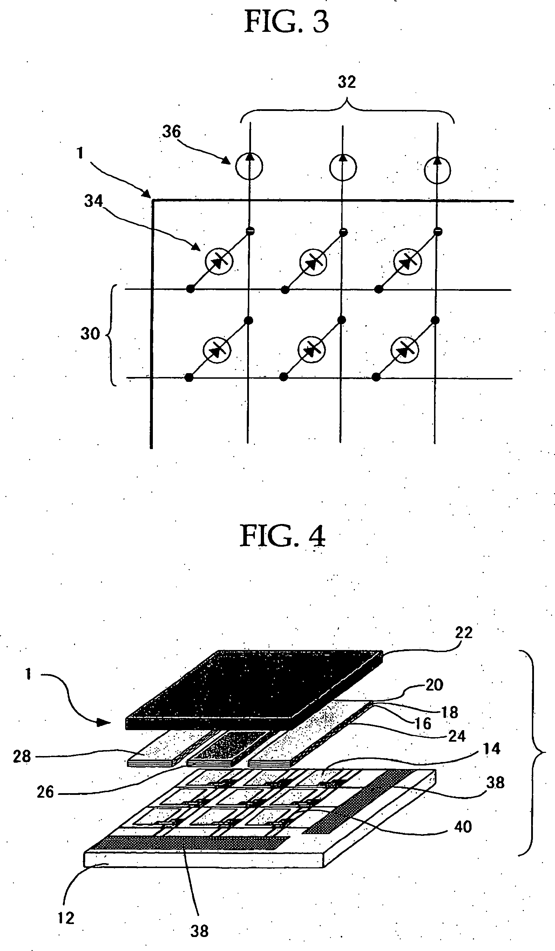

In the passive matrix panel, positive electrode lines 30 comprising a plurality of positive electrodes 14, and negative electrode lines 32 comprising a plurality of negative electrodes 22, for example intersect substantially at right angles to form a circuit, as shown in FIG. 3. Each of the Organic thin film layers 24, 26, and 28 for red light emission, blue light emission and green light emission situated at each intersection point functions as a pixel, there being a plurality of organic EL elements 34 corresponding to each pixel. In this passive matrix panel, when a current is applied by a constant-current supply 36 to one of the positive electrodes 14 in the positive electrode lines 30, and one of the negative electrodes 22 in the negative electrode lines 32, a current will be applied to an organic EL thin film layer situated at the intersection, and the organic EL thin film layer at this position will emit light. By controlling the light emission of each pixel unit, a full color picture can easily be formed.

In the active matrix panel, for example, scanning lines, data lines and current supply lines are arranged in a grid pattern on a glass substrate 12, as shown in FIG. 4. A TFT circuit 40 connected to the scanning lines and the like forming the grid pattern is disposed in each grid, and an positive electrode 14 (for example, an ITO electrode) disposed in each grid can be driven by the TFT circuit 40. On the positive electrodes 14, a belt-like organic thin film layer 24 for red light emission, organic thin film layer 26 for blue light emission and organic thin film layer 28 for green light emission, are arranged sequentially and in parallel to each other. A negative electrode 22 is further arranged so as to cover each of the organic thin film layer 24 for red light emission, organic thin film layer 26 for blue light emission and organic thin film layer 28 for green light emission. The organic thin film layer 24 for red light emission, organic thin film layer 26 for blue light emission and organic thin film layer 28 for green light emission, respectively, comprise a positive hole transport layer 16, light-emitting layer 18 and electron transport layer 20.

In the active matrix panel, as shown in FIG. 5, a plurality of scanning lines 46 are arranged in parallel to each other intersecting in substantially right angles with a plurality of data lines 42 and current supply lines 44, which are parallel to each other, to form grids, and a switching TFT 48 and driver TFT 50 are connected to each grid to form a circuit. If a current is applied from a driver circuit 38, the switching TFT 48 and driver TFT 50 can be driven for each grid. In each grid, the organic thin film elements 24, 26, and 28 for blue light emission, green light emission and red light emission function as a pixel. In this active matrix panel, if a current is applied from the driver circuit 38 to one of the scanning lines 46 arranged in the horizontal direction, and the current supply lines 44 arranged in the vertical direction, the switching TFT 48 situated at the intersection is driven, the driver TFT 50 is driven as a result, and an organic EL element 52 at this position emits light. By controlling the light emission of each pixel unit, a full color picture can easily be formed.

The organic EL display of the present invention may be conveniently used in fields of various kinds such as computers, vehicle-mounted display devices, field-ready display devices, home apparatuses, industrial apparatuses, household electric appliances, traffic display devices, clock display devices, calendar display units, luminescent screens and audio equipment.

The present invention will be illustrated in further detail with reference to several examples below, which are not intended to limit the scope of the present invention.

### (Example1)

### - Synthesis of Re(CO)₄(8-quinolinate) -

Re(CO)₄ (8-quinolinate) was synthesized using Re(CO)₅Cl and 8-quinolinate as raw materials according to the method described in Inorg. Chem.1993,1, 32, 398-401. Specifically, as shown in the following reaction equation, Re(CO)₅Cl and 8-quinoline had been reacted in toluene with stirring under reflux until generation of the HCl gas stopped. The toluene was evaporated and diethyl ether was added to let the solution cool. A yellow precipitate was filtrated and obtained precipitate was washed with diethyl ether. Then, recrystallization was performed twice using mixed solvent of acetone and diethyl ether to thereby synthesize Re(CO)₄(8-quinolinate) as an objective substance.

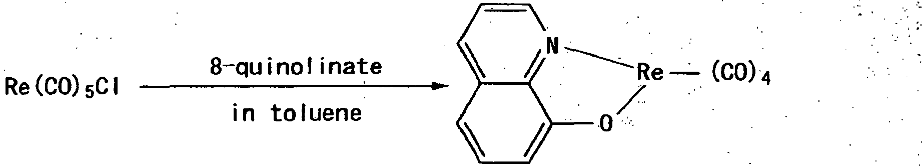

### (Example 2)

### - Synthesis of Re(CO)₄ (2-(2'-pyridyl)phenol) -

,Re(CO)₄(2-(2'-pyridyl)phenol) was synthesized as in Example 1, except that 8-quinoline was replaced by 2-(2'-pyridyl)phenol.

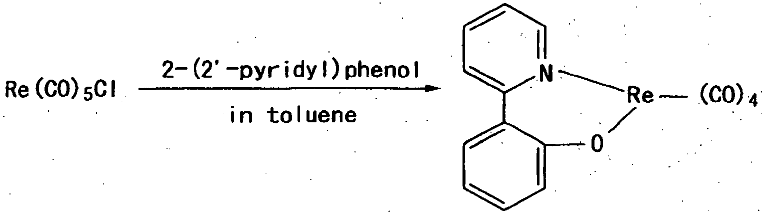

### (Example 3)

### - Synthesis of Re(CO)₂(8-quinoline)(2-(2'-pyridyl)phenol)-

Re(CO)₂(8-quinolinate)(2-(2'-pyridyl)phenol) was synthesized as in Example 1, except that Re(CO)₅Cl was replaced by Re(CO)₄Cl₂ and 8-quinolinate serving as was replaced by 8-quinolinate and 2-(2'-pyridyl)phenol (1:1). Obtained crude product was separated by column. The yield was 10 %.

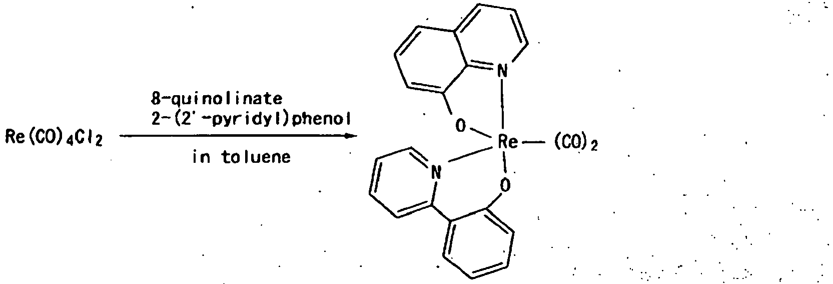

### (Example 4)

### - Synthesis of Re(8-quinolinabe)(2-(2'-pyridyl)phenol)(7,8-benzoquirioline) -

Re(8-quinolinate)(2-(2'-pyridyl)phenol)(7,8-benzoquinoline) was synthesized as in Example 1, except that Re(CO)₅Cl was replaced by ReCl₃, 8-quinolinate serving as ligand was replaced by 8-quinolinate, 2-(2'-pyridyl)phenol and 7,8-benzoquinoline and these were subsequently coordinated with Re. Product was separated by column with respect to coordination of each ligand. The total yield was about 2%.

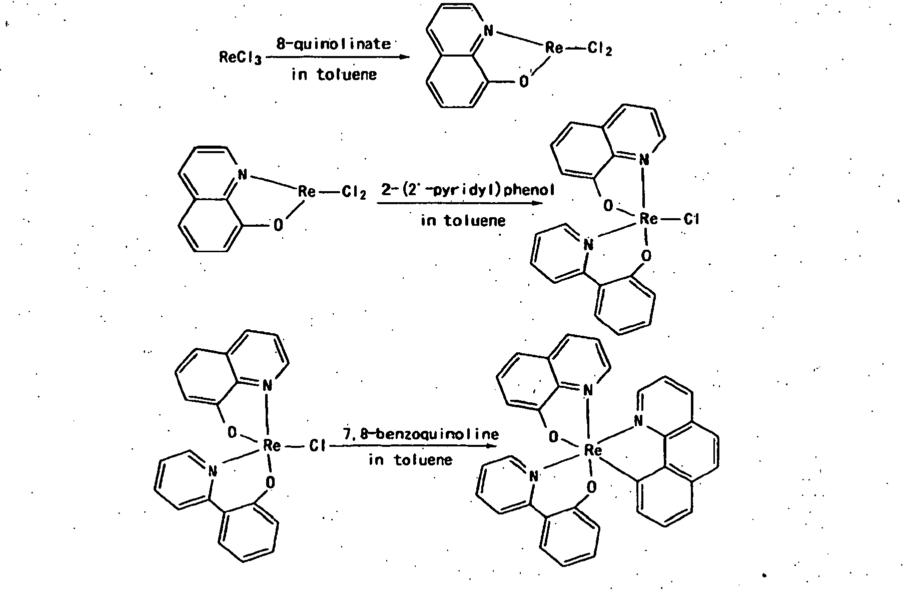

### (Example 5)

### - Manufacture of organic EL element -

Using the organic rhenium complexes respectively synthesized in Examples 1 to 4, laminated organic EL elements comprising a light-emitting layer which comprises one of the organic rhenium complexes as a luminescent material, were produced as follows. A glass substrate wherein an ITO electrode was formed as a positive electrode was subjected to ultrasonic cleaning in water, acetone and isopropyl alcohol, and after performing UV ozonization, it was coated with (N,N'-diphenyl-N,N'-bis(3-methylphenyl)-[1,1'-biphenyl]-4,4'-diamine) (TPD) to a thickness of 50nm as a positive hole transport layer on this ITO electrode using a vacuum vapor deposition system (degree of vacuum = 1x10⁻⁶Torr (1.3x10⁻⁴Pa), substrate temperature = room temperature). Next, the organic rhenium complexes respectively synthesized in Examples 1 to 7, were vapor deposited to a thickness of 20nm to form a light-emitting layer on this TPD positive hole transport layer. A vapor deposit of 2,9-dimethyl-4,7-diphenyl-1,10-phenanthroline (BCP) was then formed to a thickness of 10nm as a first electron transport layer on the light-emitting layer. Further, a vapor deposit of aluminum quinoline complex (Alq) was formed to a thickness of 20nm as a second electron transport layer on the first electron transport layer, and an Al-Li alloy (Li content = 0.5 % by mass) layer was formed as a negative electrode by vapor deposition to a thickness of 50nm on the aluminum quinoline complex (Alq) second electron transport layer. In this way, four organic EL elements were manufactured.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element, emission luminance (cd/m²) at an applied voltage of 10V and an effective half-life with an initial luminance of 100 cd/m² (by constant current measurement) was measured. The results are shown in Table 1. The numbers 1 to 4 in Table 1 refer to Examples 1 to 4, and refer to the organic rhenium complexes obtained in each example.

**Table 1**

| | Organic rhenium complex | Luminance (cd/m²) | Lifetime (hours) |
|---|---|---|---|
| 1 | Re(CO)₄(quin) | 1200 | 2000 |
| 2 | Re(CO)₄(pyph) | 1500 | 2000 |
| 3 | Re(CO)₂(quin) (pyph) | 3500 | 2000 |
| 4 | Re(quin) (pyph) (bzq) | 6000 | 1500 |

### (Example 6)

### - Manufacture of organic EL element -

Seven kinds of organic EL elements were manufactured as in Example 5, except that whereas in Example 5 the light-emitting layer was formed of only the organic rhenium complex, in this example the organic rhenium complex and 4,4'-bis(9-carbazolyl)-biphenyl (CBP) represented by the formula (13) were simultaneously deposited in such a way that there were 99 molecules (99 moles) of CBP for one molecule (1 mole) of organic rhenium complex to form the light-emitting layer.

When a voltage was applied to the ITO electrode (positive electrode) and Al-Li alloy (negative electrode) of the manufactured organic EL elements, a high color purity red light emission was observed for each element at a voltage of 5V or higher. Also, for each organic EL element, emission luminance (cd/m²) at an applied voltage of 10V and an effective half-life with an initial luminance of 100 cd/m² (by constant current measurement) was measured. The results are shown in Table 2. The numbers 1 to 4 in Table 2 refer to Examples 1 to 4, and refer to the organic rhenium complexes obtained in each example.

**Table 2**

| | Organic rhenium complex | Luminance (cd/m²) | Lifetime (hours) |
|---|---|---|---|
| 1 | Re(CO)₄(quin) | 2000 | 2000 |
| 2 | Re(CO)₄(pyph) | 2000 | 3000 |
| 3 | Re(CO)₂(quin)(pyph) | 4500 | 3000 |
| 4 | Re(quin)(pyph)(bzq) | 8000 | 2000 |

### (Example 21)

12.5 g of Re(CO)₅Cl and 1.5 g of benzo[h]quinoline were added to toluene deaerated with argon, stirred and refluxed. Toluene was evaporated and to the remaining mixture, heated hexane was added to thereby extract objective substance. The obtained yellow crude product was recrystallized several times with hexane, and thus unreacted benzoquinoline was removed. An organic rhenium complex as an objective substance was obtained by mass spectroscopy (refer to Peter Spellane, and Richard J. Watts, Inorg. Chem.32 (1993) 5633).

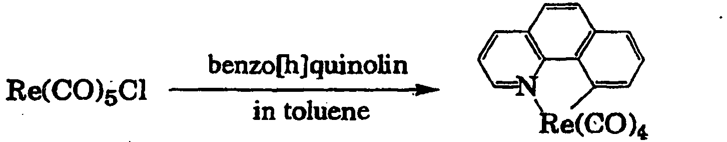

Moreover, in the same way as mentioned above, organic rhenium complexes (phosphorescent material) was synthesized (RE-002 to 004).

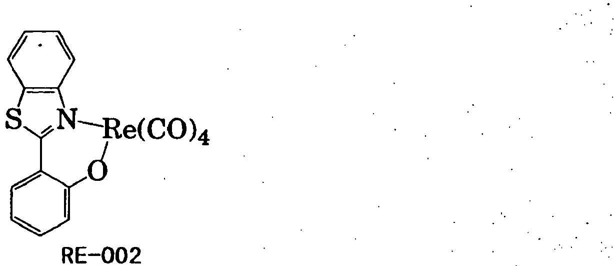

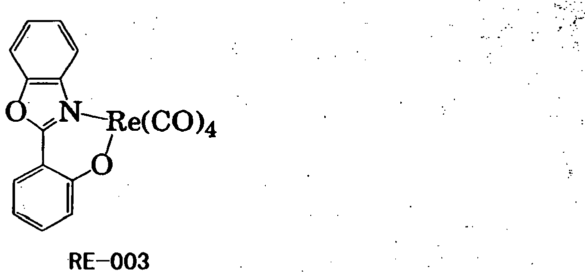

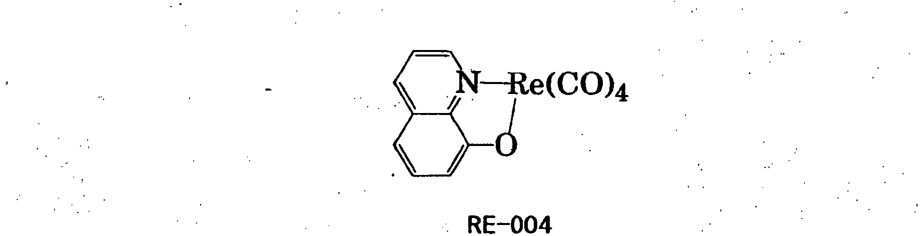

In the following, the emission wavelength of the synthesized organic rhenium complexes (RE-001 to 004) in powder form is shown in Table 10. The wavelength shows the peak wavelength of the emission spectrum observed after irradiating 365nm of excitation light.

**Table 10**

| Complex name | Emission wavelength (nm) |
|---|---|
| RE-001 | 615 nm |
| RE-002 | 532 nm |
| RE-003 | 530 nm |
| RE-004 | 653 nm |

### Industrial Applicability

The present invention, which can solve the conventional problems, provides an organometallic complex exhibiting phosphorescent luminescence suitable for use as a luminescent material, color conversion material, etc. in an organic EL element, an organic EL element having excellent lifetime, light-emitting efficiency, thermal and electrical stability, color conversion efficiency, etc., and a high performance, long lifetime organic EL display using the organometallic complex or the organic EL element, which organic EL display is suitable for a color display in which a constant average driving current can be achieved regardless of light-emitting pixels and color balance is satisfactory without changing light emitting area, etc.

The organometallic complex of the present invention exhibits phosphorescent luminescence and can be suitably used as a luminescent material, color conversion material, etc. in an organic EL element. Since the organic EL element of the present invention uses the organometallic complex, the organic EL element is excellent in lifetime, light emission efficiency, thermal and electrical stability, color conversion efficiency, etc., and can be suitably used for an organic EL display. Since the organic EL display of the present invention uses the organic EL element, the organic EL display has high performance and a long lifetime, and can be suitably used for display screens of televisions, mobile-phones, computers, etc.

## Claims

1. An organic EL element comprising:
a positive electrode,
a negative electrode, and
an organic thin film layer disposed between the positive electrode and the negative electrode;
wherein the Organic thin film layer comprises an organometallic complex,
wherein the organometallic complex comprises:
a rhenium (Re) atom,
one ligand which comprises a coordinated nitrogen atom and a coordinated oxygen atom, each coordinated with the rhenium (Re) atom, and comprises at least one π conjugation part, and
the other ligand coordinated with the rhenium (Re) atom in such a way that the ligand saturates the coordination number of the rhenium (Re) atom and the charge of the whole organometallic complex is neutral; and
wherein the organometallic complex is represented by a formula which is selected from the following formulas (1), (2) and (3): 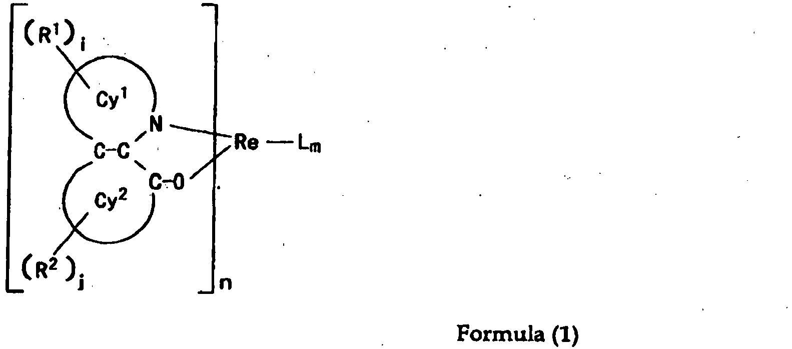 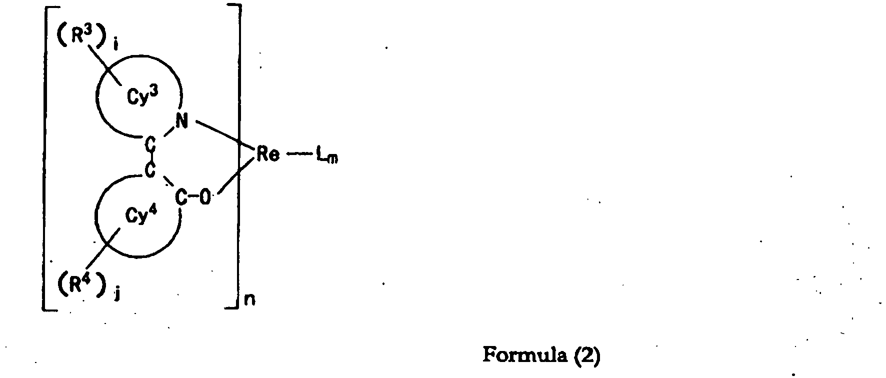 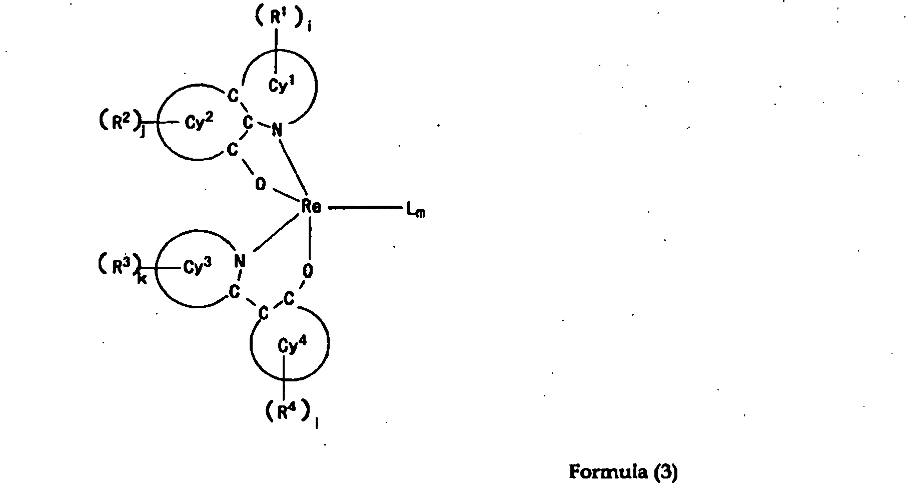
in which, in the formulas (1), (2) and (3), R¹ to R⁴ may be the same or different, and each represent a hydrogen atom or a substituent group; "i", "j", "k" and "l" are integers; Cγ¹ represents one ring structure containing a coordinated nitrogen atom which is coordinated with a rhenium (Re) atom, and two carbon atoms which are bonded to the nitrogen atom and are shared with Cγ²; Cγ² represents the other ring structure which is bonded to the oxygen atom bonded to a rhenium (Re) atom and contains the two carbon atoms shared with Cγ¹; Cy³ represents one ring structure containing a coordinated nitrogen atom which is coordinated with a rhenium (Re) atom, and a carbon atom which is bonded to the nitrogen atom and to a carbon atom in Cγ⁴; Cγ⁴ represents the other ring structure containing a carbon atom which is bonded to the oxygen atom bonded to a rhenium (Re) atom and a carbon atom which is bonded to a carbon atom in Cγ³; the letter "L" represents the other ligand which saturates the coordination number of the rhenium (Re) atom, and neutralizes the charge of the whole complex; "m" represents 1 or 2; and "n" represents 1,2 or 3.

2. An organic EL element according to claim 1,
wherein the organic EL element comprises a color conversion layer, and
the color conversion layer is capable of emitting phosphorescence and is capable of converting incident light into light having a wavelength longer than the wavelength thereof by 100 nm or more.

3. An organic EL element according to claim 2, wherein the color conversion layer is capable of converting incident light into light having a wavelength longer than the wavelength thereof by 150 nm or more.

4. An organic EL element according to one of claims 2 and 3, wherein the color conversion layer is capable of converting light in the wavelength range of ultraviolet light to blue light into red light.

5. An organic EL element according to any one of claims 2 to 4, wherein the color conversion layer comprises at least one selected from (1) an organometallic complex which comprises a rhenium (Re) atom; one ligand which comprises a coordinated nitrogen atom and a coordinated oxygen atom, each coordinated with the rhenium (Re) atom, and comprises at least one π conjugation part; and the other ligand coordinated with the rhenium (Re) atom in such a way that the ligand saturates the coordination number of the rhenium (Re) atom and the charge of the whole organometallic complex is neutral, (2) an organometallic complex which comprises an rhenium (Re) atom; one ligand which comprises a coordinated nitrogen atom, a coordinated carbon atom, each coordinated with the rhenium (Re) atom, and comprises at least one π conjugation part; and the other ligand coordinated with the rhenium (Re) atom in such a way that the ligand saturate the coordination number of the rhenium (Re) atom and the charge of the whole organometallic complex is neutral, and (3) an organometallic complex which comprises at least one of Group 8 metal atoms selected from Group 8 metal element; one ligand which comprises at least one π conjugation part and is coordinated with the Group 8 metal atom; and a dithiolate ligand which is selected from an aliphatic dithiolate ligand and a heteroaromatic dithiolate ligand, and is coordinated with the Group 8 metal atom.

6. An organic EL element according to any one of claims 1 to 5, which is used for lighting units.

7. An organometallic complex which is represented by a formula which is selected from the following formulas (1), (2) and (3): 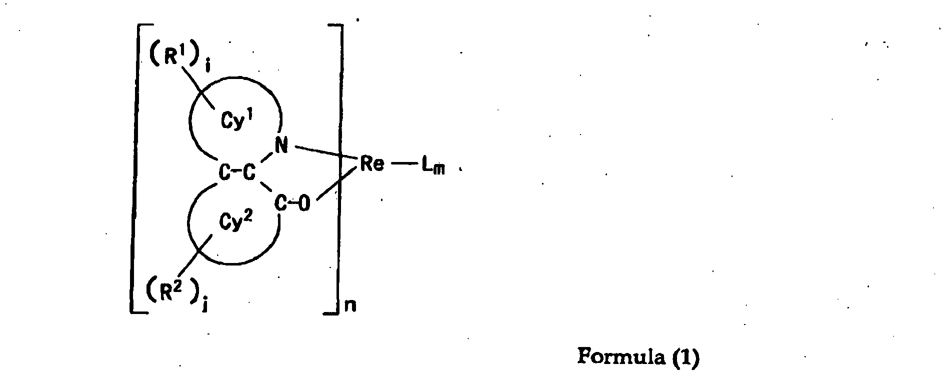 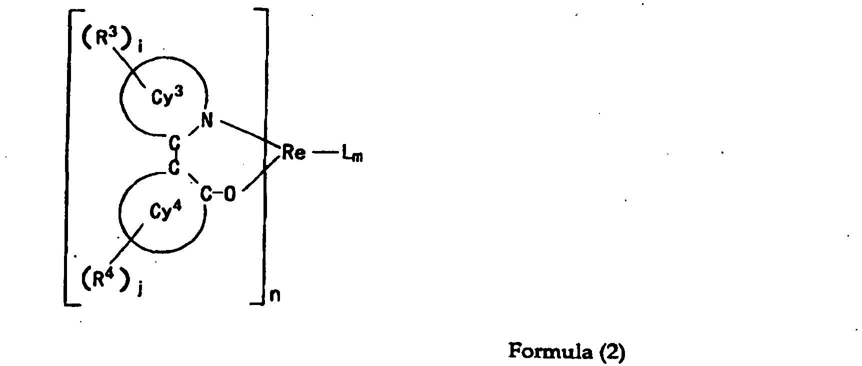 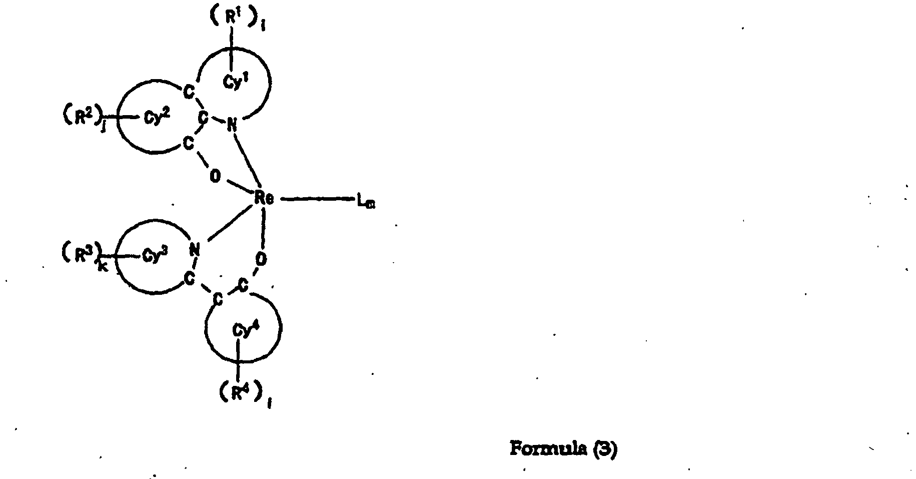 in which, in the formulas (1), (2) and (3), R¹ to R⁴ may be the same or different, and each represent a hydrogen atom or a substituent group; "i", "j", "k" and "l" are integers; Cγ¹ represents one ring structure containing a coordinated nitrogen atom which is coordinated with a rhenium (Re) atom, and two carbon atoms which are bonded to the nitrogen atom and are shared with Cγ²; Cγ² represents the other ring structure which is bonded to the oxygen atom bonded to a rhenium (Re) atom and contains the two carbon atoms shared with Cγ¹; Cγ³ represents one ring structure containing a coordinated nitrogen atom which is coordinated with a rhenium (Re) atom, and a carbon atom which is bonded to the nitrogen atom and to a carbon atom in Cγ⁴; Cγ⁴ represents the other ring structure containing a carbon atom which is bonded to the oxygen atom bonded to a rhenium (Re) atom and a carbon atom which is bonded to a carbon atom in Cγ³; the letter "L" represents the other ligand which saturates the coordination number of the rhenium (Re) atom, and neutralizes the charge of the whole complex; "m" represents 1 or 2; and "n" represents 1, 2 or 3.

8. An organometallic complex according to claim 7, which is used as at least one of a luminescent material and a color conversion material.

9. An organic EL display, comprising the organic EL element according to any one of claims 1 to 6.

10. An organic EL display according to claim 9, further comprising:
a pair of electrodes;
an organic thin film layer disposed between the pair of electrodes which is capable of emitting EL light; and
a color conversion layer,
wherein at least one of the pair of electrodes is transparent and at least one of the pair of electrodes corresponds to pixels,
wherein the color conversion layer is arranged on at least a green pixel and a red pixel in the pixels.

11. An organic EL display according to one of claims 9 and 10, further comprising:
a color conversion layer arranged on a blue pixel; and
a color conversion layer arranged on a red pixel,
wherein light-emitting light, due to EL luminescence is white light,
wherein the color conversion layer arranged on a red pixel comprises at least one selected from the organometallic complex according to claim 7.

12. An organic EL display according to one of claims 9 and 10, further comprising:
a color conversion layer arranged on a red pixel; and
wherein light-emitting light due to EL luminescence is blue light,
wherein the color conversion layer arranged on a red pixel comprises at least one selected from the organometallic complex according to one of claims 7 and 8.

## Patentansprüche

1. Ein organisches EL Element umfassend:
eine positive Elektrode,
eine negative Elektrode, und
eine organische Dünnfilmschicht, angeordnet zwischen der positiven Elektrode und der negativen Elektrode;
wobei die organische Dünnfilmschicht einen metallorganischen Komplex umfasst,
wobei der metallorganische Komplex folgende Bestandteile umfasst:
ein Rhenium (Re) Atom;
einen Liganden, welcher ein koordiniertes Stickstoffatom und ein koordiniertes Sauerstoffatom, welche jeweils mit dem Rhenium (Re) Atom koordiniert sind, und zumindest einen π-konjugierten Abschnitt umfasst, und der andere Ligand mit dem Rhenium (Re) Atom in einer solchen Weise koordiniert ist, dass der Ligand die Koordinationszahl des Rhenium (Re) Atoms absättigt und die Ladung des gesamten,
metallorganischen Komplexes neutral ist; und
wobei der metallorganische Komplex dargestellt wird durch eine Formel ausgewählt aus den folgenden Formeln (1), (2) und (3): 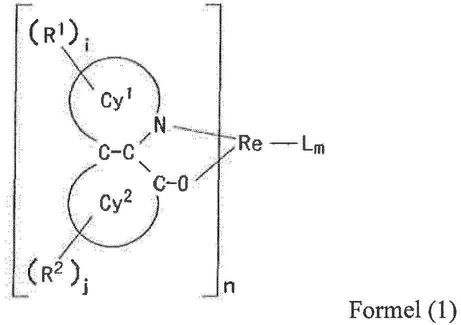 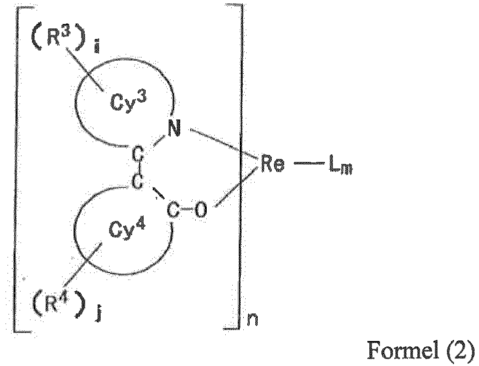 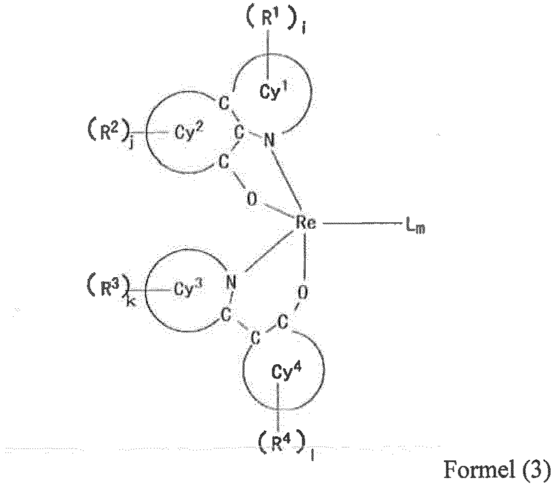 wobei
in den Formeln (1), (2) und (3), R¹ bis R⁴ gleich oder unterschiedlich sein können, und jeweils ein Wasserstoffatom oder eine Substituentengruppe darstellen;
"i", "j", "k" und "l" Ganzzahlen sind;
Cy₁ eine cyclische Struktur darstellt, enthaltend ein koordiniertes Stickstoffatom, welches mit einem Rhenium (Re) Atom koordiniert ist, und zwei Kohlenstoffatome, welche an das Stickstoffatom gebunden sind und mit Cy² geteilt werden;
Cy² die andere cyclische Struktur darstellt, welche an das Sauerstoffatom gebunden ist, dass an ein Rhenium (Re) Atom gebunden ist und die zwei Kohlenstoffe enthält, die mit Cy¹ geteilt werden;
Cy³ eine cyclische Struktur darstellt, enthaltend ein koordiniertes Stickstoffatom, welches koordiniert ist mit einem Rhenium (Re) Atom, und ein Kohlenstoffatom, welches gebunden ist an das Stickstoffatom und ein Kohlenstoffatom in Cy⁴;
Cy⁴ die andere cyclische Struktur darstellt, enthaltend ein Kohlenstoffatom, welches an das Sauerstoffatom gebunden ist, dass an ein Rhenium (Re) Atom gebunden ist, und ein Kohlenstoffatom, welches an ein Kohlenstoffatom in Cy³ gebunden ist;
der Buchstabe "L" den anderen Liganden darstellt, welcher die Koordinationszahl des Rhenium (Re) Atoms absättigt, und die Ladung des gesamten Komplexes neutralisiert;
"m" 1 oder 2 darstellt;
"n" 1, 2, oder 3 darstellt.

2. Ein organisches EL Element gemäß Anspruch 1, wobei das organische EL Element eine Farbumwandlungsschicht umfasst, und die Farbumwandlungsschicht fähig ist, Phosphoreszenz zu emittieren, und fähig ist einfallendes Licht in Licht mit einer Wellenlänge zu konvertieren, die um 100 nm oder mehr größer ist, als die Wellenlänge des einfallenden Lichts.

3. Ein organisches EL Element gemäß Anspruch 2, wobei die Farbumwandlungsschicht fähig ist, einfallendes Licht in Licht mit einer Wellenlänge zu konvertieren, die um 150 nm oder mehr größer ist, als die Wellenlänge des einfallenden Lichts.

4. Ein organisches EL Element gemäß einem der Ansprüche 2 und 3, wobei die Farbumwandlungsschicht fähig ist, Licht in dem Wellenlängenbereich von ultraviolettem Licht bis blauem Licht, in rotes Licht zu konvertieren.

5. Ein organisches EL Element gemäß einem der Ansprüche 2 bis 4, wobei die Farbkonversionsschicht zumindest einem, ausgewählt aus den folgenden umfasst:
(1) ein metallorganischer Komplex umfassend
ein Rhenium (Re) Atom;
einen Liganden umfassend ein koordiniertes Stickstoffatom und ein koordiniertes Sauerstoffatom, welche jeweils mit dem Rhenium (Re) Atom koordiniert sind, umfassend zumindest einem π-konjugierten Abschnitt;
und der andere Ligand mit dem Rhenium (Re) Atom in einer solchen Weise koordiniert ist, dass der Ligand die Koordinationszahl des Rhenium (Re) Atoms absättigt, und die Ladung des gesamten, metallorganischen Komplexes neutral ist;
(2) ein metallorganischer Komplex, umfassend
ein Rhenium (Re) Atom;
ein Ligand umfassend ein koordiniertes Stickstoffatom, ein koordiniertes Kohlenstoffatom, jeweils koordiniert mit dem Rhenium (Re) Atom, und zumindest ein π-konjungierten Abschnitt;
und der andere Ligand mit dem Rhenium (Re) Atom in einer solchen Weise koordiniert ist, dass der Ligand die Koordinationszahl des Rhenium (Re) Atoms absättigt und die Ladung des gesamten metallorganischen Komplexes neutral ist,
und
(3) ein metallorganischer Komplex umfassend
zumindest eines von Gruppe 8 Metallatomen, ausgewählt aus Gruppe 8 Metallelement;
ein Ligand welcher zumindest einen π-konjungierten Abschnitt aufweist und mit dem Gruppe 8 Metallatom koordiniert ist;
und einen Dithiolat-Ligand, ausgewählt aus einem aliphatischen Dithiolat-Liganden und einem heteroaromatischen Dithiolat-Liganden, der mit dem Gruppe 8 Metallatom koordiniert ist.

6. Ein organisches EL Element gemäß einem der Ansprüche 1 bis 5, welches für Beleuchtungsvorrichtungen verwendet wird.

7. Ein metallorganischer Komplex gemäß einer Formel ausgewählt aus den folgenden Formeln (1), (2) und (3): 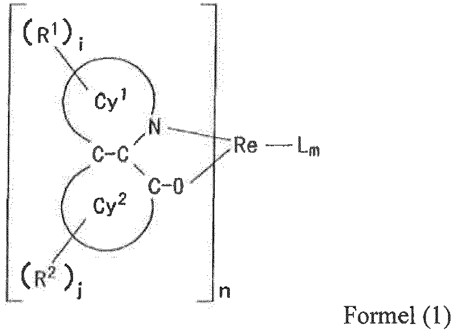 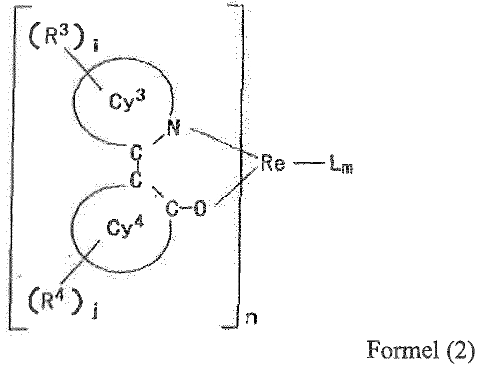 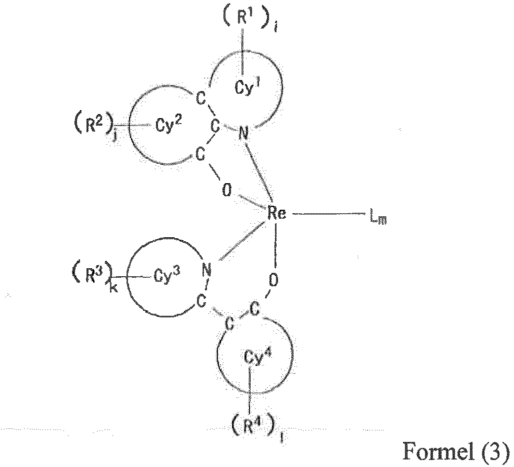 wobei
in den Formeln (1), (2) und (3), R¹ bis R⁴ gleich oder unterschiedlich sein können, und jeweils ein Wasserstoffatom oder eine Substituentengruppe darstellen;
"i", "j", "k" und "l" Ganzzahlen sind;
Cy₁ eine cyclische Struktur darstellt, enthaltend ein koordiniertes Stickstoffatom, welches mit einem Rhenium (Re) Atom koordiniert ist, und zwei Kohlenstoffatome, welche an das Stickstoffatom gebunden sind und mit Cy² geteilt werden;
Cy² die andere cyclische Struktur darstellt, welche an das Sauerstoffatom gebunden ist, dass an ein Rhenium (Re) Atom gebunden ist und die zwei Kohlenstoffe enthält die mit Cy¹ geteilt werden;
Cy³ eine cyclische Struktur darstellt, enthaltend ein koordiniertes Stickstoffatom, welches koordiniert ist mit einem Rhenium (Re) Atom, und ein Kohlenstoffatom, welches gebunden ist an das Stickstoffatom und ein Kohlenstoffatom in Cy⁴;
Cy⁴ die andere cyclische Struktur darstellt, enthaltend ein Kohlenstoffatom, welches an das Sauerstoffatom gebunden ist, dass an ein Rhenium (Re) Atom gebunden ist, und ein Kohlenstoffatom, welches an ein Kohlenstoffatom in Cy³ gebunden ist;
der Buchstabe "L" den anderen Liganden darstellt, welcher die Koordinationszahl des Rhenium (Re) Atoms absättigt, und die Ladung des gesamten Komplexes neutralisiert;
"m" 1 oder 2 darstellt;
"n" 1, 2, oder 3 darstellt.

8. Ein metallorganischer Komplex gemäß Anspruch 7, welcher verwendet wird als zumindest eines von einem Lumineszenzmaterial und einem Farbkonversionsmaterial.

9. Ein organisches EL Display, umfassend das organische EL Element gemäß einem der Ansprüche 1 bis 6.

10. Ein organisches EL Display gemäß Anspruch 9, weiterhin umfassend:
ein Elektrodenpaar;
eine organische Dünnfilmschicht angeordnet zwischen dem Elektrodenpaar, welche fähig ist EL Licht zu emittieren; und
eine Farbkonversionsschicht,
wobei zumindest eine Elektrode des Elektrodenpaars transparent ist und zumindest eine Elektrode des Elektrodenpaares Pixeln entspricht,
wobei die Farbumwandlungsschicht auf zumindest einem grünen Pixel und einem roten Pixel in den Pixeln angeordnet ist.

11. Ein organisches EL Display gemäß einem der Ansprüche 9 und 10 weiterhin umfassend:
eine Farbumwandlungsschicht angeordnet auf einem blauen Pixel; und
eine Farbumwandlungsschicht angeordnet auf einem roten Pixel,
wobei das durch EL Lumineszenz emittierte Licht weiß ist, und
die auf einem roten Pixel angeordnete Farbkonversionsschicht zumindest einen der metallorganischen Komplexe gemäß Anspruch 7 umfasst.

12. Ein organisches EL Display gemäß einem der Ansprüche 9 und 10, weiterhin umfassend:
eine Farbkonversionsschicht angeordnet auf einem roten Pixel;
wobei das durch EL Lumineszenz emittierte Licht blau ist, und die die auf einem roten Pixel angeordnete Farbkonversionsschicht zumindest einem der metallorganischen Komplexe gemäß einem der Ansprüche 7 oder 8 umfasst.

## Revendications

1. Élément organique EL comportant :
une électrode positive,
une électrode négative, et
une couche de film mince organique disposée entre l'électrode positive et l'électrode négative ;
dans lequel la couche de film mince organique comporte un complexe organométallique,
dans lequel le complexe organométallique comporte :
un atome de rhénium (RE),
un ligand qui comprend un atome d'azote coordonné et un atome d'oxygène coordonné, chacun étant coordonné avec l'atome de rhénium (Re), et comportant au moins une partie de conjugaison π , et
l'autre ligand coordonné avec l'atome de rhénium (Re) de manière à ce que le ligand sature le nombre de coordination de l'atome de rhénium (Re) et la charge du complexe organométallique entier est neutre ; et
dans lequel le complexe organométallique est représenté par une formule qui est choisie à partir des formules suivantes (1), (2) et (3) : 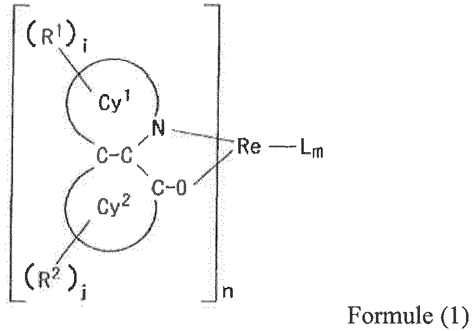 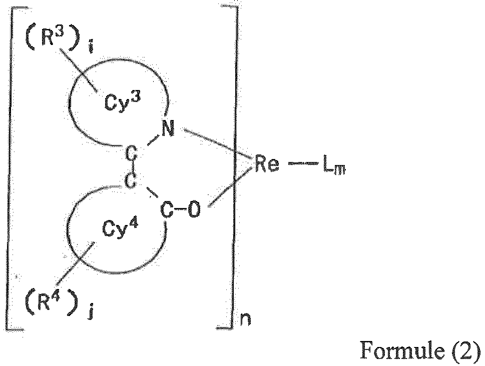 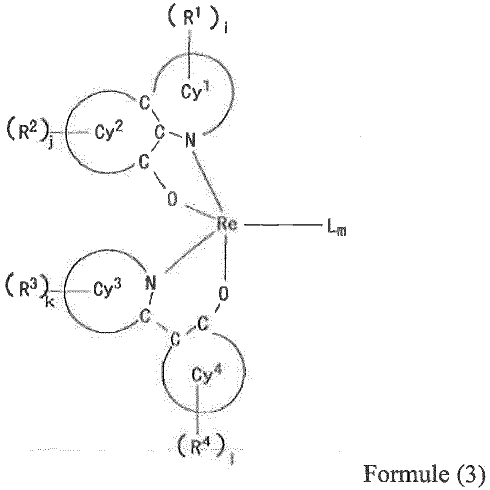 où, dans les formules (1), (2) et (3), R¹ à R⁴ peuvent être identiques ou différents, et chacun représentant un atome d'hydrogène ou un groupe substituant ; "i", "j", "k" et "I" sont des nombres entiers ; Cy¹ représente une structure en anneau contenant un atome d'azote coordonné qui est coordonné avec un atome de rhénium (Re), et deux atomes de carbone qui sont liés à l'atome d'azote et sont partagés avec Cy² ;Cy² représente l'autre structure en anneau qui est liée à l'atome d'oxygène lié à un atome de rhénium (Re) et contient les deux atomes de carbone partagés avec Cy¹ ; Cy³ représente une structure en anneau contenant un atome d'azote coordonné qui est coordonné avec un atome de rhénium (Re), et un atome de carbone qui est lié à l'atome d'azote et à un atome de carbone dans Cy⁴ ; Cy⁴ représente l'autre structure en anneau contenant un atome de carbone qui est lié à l'atome d'oxygène lié à un atome de rhénium (Re) et un atome de carbone qui est lié à un atome de carbone dans Cy³ ; la lettre "L" représente l'autre ligand qui sature le nombre de coordination de l'atome de rhénium (Re), et neutralise la charge du complexe entier ; "m" représente 1 ou 2 ; et "n" représente 1, 2 ou 3.

2. Élément organique EL selon la revendication 1,
dans lequel l'élément organique EL comporte une couche de conversion de couleurs, et
la couche de conversion de couleurs est capable d'émettre une phosphorescence et est capable de convertir une lumière incidente en lumière ayant une longueur d'onde supérieure à la longueur d'onde de celle-ci de 100 nm ou plus.

3. Élément organique EL selon la revendication 2, dans lequel la couche de conversion de couleurs est capable de convertir une lumière incidente en lumière ayant une longueur d'onde supérieure à la longueur d'onde de celle-ci de 150 nm ou plus.

4. Élément organique EL selon l'une des revendications 2 et 3, dans lequel la couche de conversion de couleurs est capable de convertir une lumière dans la plage de longueurs d'onde de la lumière ultraviolette de lumière bleue en lumière rouge.

5. Élément organique EL selon l'une des revendications 2 à 4, dans lequel la couche de conversion de couleurs comporte au moins l'un choisi parmi (1) un complexe organométallique qui comporte un atome de rhénium (Re) ; un ligand qui comporte un atome d'azote coordonné et un atome d'oxygène coordonné, chacun étant coordonné avec l'atome de rhénium (Re), et comporte au moins une partie de conjugaison π , et l'autre ligand coordonné avec l'atome de rhénium (Re) de manière à ce que le ligand sature le nombre de coordination de l'atome de rhénium (Re) et la charge du complexe organométallique entier est neutre, (2) un complexe organométallique qui comporte un atome de rhénium (Re) ; un ligand qui comporte un atome d'azote coordonné, un atome de carbone coordonné, chacun étant coordonné avec l'atome de rhénium (Re), et comporte au moins une partie de conjugaison π , et l'autre ligand coordonné avec l'atome de rhénium (Re) de manière à ce que le ligand sature le nombre de coordination de l'atome de rhénium (Re) et la charge du complexe organométallique entier est neutre, et (3) un complexe organométallique comporte au moins l'un des atomes de métal du Groupe 8 choisis parmi un élément métallique du Groupe 8 ; un ligand qui comporte au moins une partie de conjugaison π et est coordonné avec l'atome de métal du Groupe 8 ; et un ligand dithiolate qui est choisi parmi un ligand dithiolate aliphatique et un ligand dithiolate hétéro aromatique, et est coordonné avec l'atome de métal du Groupe 8.

6. Élément organique EL selon l'une des revendications 1 à 5, lequel est utilisé pour des unités de lumière.

7. Complexe organométallique qui est représenté par une formule qui est choisie parmi les formules suivantes (1), (2) et (3) : 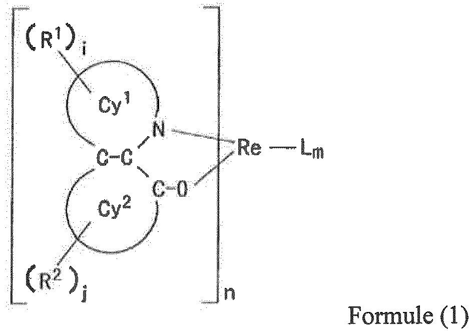 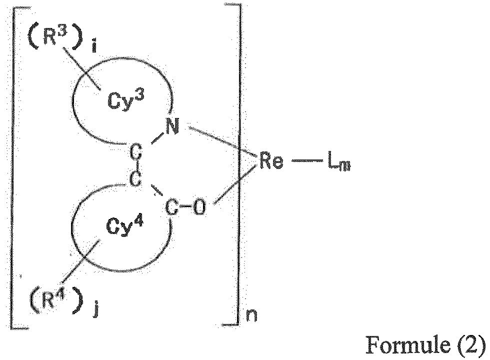 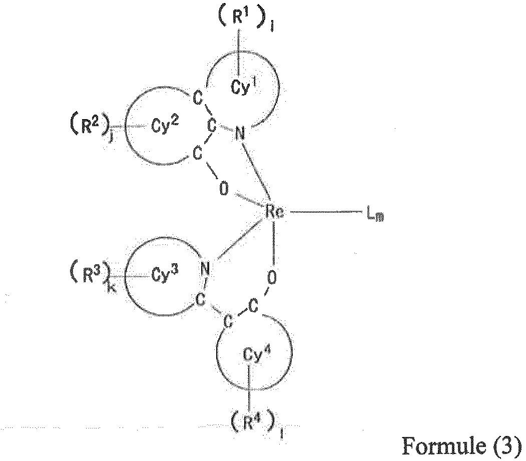 où, dans les formules (1), (2) et (3), R¹ à R⁴ peuvent être identiques ou différents, et chacun représentant un atome d'hydrogène ou un groupe substituant ; "i", "j", "k" et "I" sont des nombres entiers ; Cy¹ représente une structure en anneau contenant un atome d'azote coordonné qui est coordonné avec un atome de rhénium (Re), et deux atomes de carbone qui sont liés à l'atome d'azote et sont partagés avec Cy² ;Cy² représente l'autre structure en anneau qui est liée à l'atome d'oxygène lié à un atome de rhénium (Re) et contient les deux atomes de carbone partagés avec Cy¹ ; Cy³ représente une structure en anneau contenant un atome d'azote coordonné qui est coordonné avec un atome de rhénium (Re), et un atome de carbone qui est lié à l'atome d'azote et à un atome de carbone dans Cy⁴ ; Cy⁴ représente l'autre structure en anneau contenant un atome de carbone qui est lié à l'atome d'oxygène lié à un atome de rhénium (Re) et un atome de carbone qui est lié à un atome de carbone dans Cy³ ; la lettre "L" représente l'autre ligand qui sature le nombre de coordination de l'atome de rhénium (Re), et neutralise la charge du complexe entier ; "m" représente 1 ou 2 ; et "n" représente 1, 2 ou 3.

8. Complexe organométallique selon la revendication 7, lequel est utilisé sous forme d'au moins l'un d'un matériau luminescent et d'un matériau de conversion de couleurs.

9. Écran organique EL, comportant l'élément organique EL selon l'une quelconque des revendications 1 à 6.

10. Écran organique EL selon la revendication 9, comportant en outre :
une paire d'électrodes ;
une couche de film mince organique disposée entre la paire d'électrodes qui est capable d'émettre une lumière EL ; et
une couche de conversion de couleurs,
dans lequel au moins l'une des électrodes de la paire d'électrodes est transparente et au moins l'une des électrodes de la paire d'électrodes correspond à des pixels,
dans lequel la couche de conversion de couleurs est disposée sur au moins un pixel vert et un pixel rouge dans les pixels.

11. Écran organique EL selon l'une des revendications 9 et 10, comportant en outre :
une couche de conversion de couleurs disposée sur un pixel bleu ; et
une couche de conversion de couleurs disposée sur un pixel rouge, dans lequel la lumière d'émission de lumière due à une luminescence EL est une lumière blanche,
dans lequel la couche de conversion de couleurs disposée sur un pixel rouge comporte au moins un complexe organométallique choisi parmi le complexe organométallique selon la revendication 7.

12. Écran organique EL selon l'une des revendications 9 et 10, comportant en outre :
une couche de conversion de couleurs disposée sur un pixel rouge ; et
dans lequel la lumière d'émission de lumière due à une luminescence EL est une lumière bleue,
dans lequel la couche de conversion de couleurs disposée sur un pixel rouge comporte au moins un complexe organométallique choisi parmi le complexe organométallique selon l'une des revendications 7 et 8.
